(19) Europäisches Patentamt
European Patent Office
Office européen des brevets

(11) **EP 4 753 429 A2**

(12) **EUROPEAN PATENT APPLICATION**

(43) Date of publication:
03.06.2026 Bulletin 2026/23

(21) Application number: 26170711.1

(22) Date of filing: 26.10.2022

(51) International Patent Classification (IPC):
**H10K 59/65** (2023.01)

(52) Cooperative Patent Classification (CPC):
**H10K 59/121; H10K 59/1213; H10K 59/8731;**
H10K 59/131; H10K 59/38; H10K 59/40;
H10K 59/65; H10K 59/879; H10K 59/8792

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: 16.11.2021 KR 20210157219

(62) Document number(s) of the earlier application(s) in accordance with Art. 76 EPC:
**22203894.5 / 4 181 648**

(71) Applicant: **Samsung Display Co., Ltd.**
**Yongin-si, Gyeonggi-do 17113 (KR)**

(72) Inventors:
• **LEE, Jeong Seok**
**Yongin-si (KR)**
• **PARK, Woo Cheol**
**Asan-si (KR)**
• **YOON, Kwan Hyuck**
**Seoul (KR)**
• **LEE, Hye Kyun**
**Seoul (KR)**

(74) Representative: **Marks & Clerk LLP**
**15 Fetter Lane**
**London EC4A 1BW (GB)**

Remarks:
This application was filed on 02-04-2025 as a divisional application to the application mentioned under INID code 62.

(54) **DISPLAY DEVICE**

(57) A display device includes: a substrate including a first display area, a second display area including a light-transmitting part, and a third display area between the first and second display areas; a first subpixel including a first TFT on the first display area and a first light-emitting element on and electrically connected to the first TFT; a second subpixel including a second TFT on the third display area and a second light-emitting element, which is on the second display area and does not overlap with the second TFT in a plan view; a thin-film encapsulation layer on the first and second subpixels,; and a first transparent conductive layer between the second TFT and the second light-emitting element to electrically connect the second TFT and the second light-emitting element. The thin-film encapsulation layer has a refractive index of about 1.5 to about 1.7.

**FIG. 1**

DA: MDA, SDA
SDA: SDAa, SDAb

EP 4 753 429 A2

**Description**

BACKGROUND

1. Field

The disclosure relates to a display device.

2. Description of the Related Art

An electronic device such as a smartphone, a tablet personal computer ("PC"), a digital camera, a notebook computer, a navigation device, or a smart television ("TV") includes a display device for displaying an image.

A display device may include various optical devices such as an image sensor for capturing an image of the top surface of the display device, a proximity sensor for determining the presence of a user at the front of the display device, an illumination sensor for sensing the illuminance at the front of the display device, and an iris sensor for recognizing the user's iris.

As the display device has been applied to a variety of electronic devices, the demand for the display device with various design features has increased. For example, the display device may have a display area widened by eliminating holes from the front thereof. In this example, optical devices that are previously disposed at the front of the display device may be arranged to overlap with a display panel.

SUMMARY

Aspects of the disclosure provide a display device capable of improving the modulation transfer function ("MTF") of a camera sensor disposed in an area that displays an image, and at the same time, transmits light therethrough.

Aspects of the disclosure also provide a display device capable of improving the transmittance of an area that displays an image, and at the same time, transmits light therethrough.

However, aspects of the disclosure are not restricted to those set forth herein. The above and other aspects of the disclosure will become more apparent to one of ordinary skill in the art to which the disclosure pertains by referencing the detailed description of the disclosure given below.

According to an embodiment of the disclosure, a display device includes: a substrate including a first display area, a second display area, which is surrounded by the first display area and includes a light-transmitting part, and a third display area, which is disposed between the first display area and the second display area, where the light-transmitting part transmits light therethrough; a first subpixel including a first thin-film transistor ("TFT"), which is disposed on the first display area of the substrate, and a first light-emitting element, which is disposed on the first TFT and is electrically connected to the first TFT; a second subpixel including a second TFT, which is disposed on the third display area of the substrate, and a second light-emitting element, which is disposed on the second display area of the substrate and does not overlap with the second TFT in a plan view; a thin-film encapsulation layer including a first encapsulation inorganic layer, which is disposed on the first and second subpixels, an encapsulation organic layer, which is disposed on the first encapsulation inorganic layer, and a second encapsulation inorganic layer, which is disposed on the encapsulation organic layer; and a first transparent conductive layer disposed between the second TFT and the second light-emitting element to electrically connect the second TFT and the second light-emitting element. Each of the first encapsulation inorganic layer, the encapsulation organic layer, and the second encapsulation inorganic layer has a refractive index of about 1.5 to about 1.7.

In an embodiment, the display device may further include: a touch sensor layer disposed on the thin-film encapsulation layer. The touch sensor layer may include a first touch insulating layer, which is disposed on the second encapsulation inorganic layer, a first touch conductive layer, which is disposed on the first touch insulating layer, a second touch insulating layer, which is disposed on the first touch conductive layer, a second touch conductive layer, which is disposed on the second touch insulating layer, and a touch protection layer, which is disposed on the second touch conductive layer. The first and second touch conductive layers may not overlap with the light-transmitting part in the plan view, and each of the first touch insulating layer, the second touch insulating layer, and the touch protection layer may have a refractive index of about 1.5 to about 1.7.

In an embodiment, the display device may further include: an overcoat layer disposed on the touch sensor layer. The overcoat layer may include an overcoat material layer, and the overcoat material layer may have a refractive index of about 1.5 to about 1.7.

In an embodiment, the first encapsulation inorganic layer, the encapsulation organic layer, the second encapsulation inorganic layer, the first touch insulating layer, the second touch insulating layer, the touch protection layer, and the overcoat layer have the same refractive index.

In an embodiment, the display device may further include: a third subpixel including a third TFT, which is disposed on the third display area of the substrate and a third light-emitting element, which is disposed on the second display area of the substrate and does not overlap with the third TFT in the plan view; a second transparent conductive layer disposed between the third TFT and the third light-emitting element to electrically connect the third TFT and the third light-emitting element; a first via-insulating layer disposed between the substrate and the second and third light-emitting elements; and a third via-insulating layer disposed between the first via-insulating layer and the second light-emitting element and between the first via-insulating layer and the third light-emitting element. The second light-emitting element of the second subpixel and the third light-emitting element of the third subpixel may be spaced apart from each other by the light-transmitting part, the first transparent conductive layer may be disposed between the third via-insulating layer and the second light-emitting element, and the second transparent conductive layer may be disposed between the first via-insulating layer and the third via-insulating layer.

In an embodiment, the first light-emitting element may include a first cathode, which is disposed below the first encapsulation inorganic layer, the second light-emitting element may include a second cathode, which is disposed below the first encapsulation inorganic layer, the display device may further include an optical compensation layer, which is disposed between the second cathode and the first encapsulation inorganic layer, an opening, which exposes the light-transmitting part, may be defined in the second cathode, the optical compensation layer may include a low refractive index layer, which is disposed on the second cathode, and a high refractive index layer, which is disposed on the low refractive index layer, the low refractive index layer may have a refractive index of about 1.5 or less, and the high refractive index layer may have a refractive index of about 1.8 or greater.

In an embodiment, the encapsulation organic layer may have a haze of about 4% or less.

In an embodiment, the encapsulation organic layer may have a peak-to-valley ("P-V") wavefront value of about 2 micrometers ($\mu$m).

In an embodiment, the display device may further include: an optical device disposed below the substrate, and the optical device may be disposed to overlap with the second display area of the substrate in the plan view.

According to another embodiment of the disclosure, a display device includes: a substrate including a first display area, a second display area, which is surrounded by the first display area and includes a light-transmitting part, and a third display area, which is disposed between the first display area and the second display area, where the light-transmitting part transmits light therethrough; thin-film transistors (TFTs) disposed on the substrate; a first via-insulating layer disposed on the TFT, and overlapping with the first and second display areas in a plan view; a second via-insulating layer disposed on the first via-insulating layer, where the second via-insulating layer overlaps with the first display area, but does not overlap with the second display area in the plan view; a third via-insulating layer disposed on the second via-insulating layer and overlapping with the first and second display areas; light-emitting elements disposed on the third via-insulating layer, and overlapping with the first and second display areas; and a thin-film encapsulation layer disposed on the light-emitting elements. A haze of the second display area is less than a haze of the first display area.

In an embodiment, a value of the haze of the second display area may be 4% or less.

In an embodiment, the second display area may have a smaller peak-to-valley (P-V) wavefront value than the first display area.

In an embodiment, the second display area may have a P-V wavefront value of about 2 $\mu$m or less.

In an embodiment, the light-emitting elements may include a first light-emitting element, which overlaps with the first display area, but not with the second display area, and a plurality of second light-emitting elements, which overlap with the second display area, but not with the first display area in the plan view, and the second light-emitting elements may be spaced apart from each other by the light-transmitting part.

In an embodiment, the display device may further include: a third display area disposed between the first display area and the second display area. The TFTs may include a first TFT, which is disposed on the first display area and electrically connected to the first light-emitting element, and a plurality of second TFTs, which are disposed on the third display area and electrically connected to the second light-emitting elements, the first TFT overlaps with the first light-emitting element in the plan view, and the second TFTs may not overlap with the second light-emitting elements in the plan view.

In an embodiment, each of the second light-emitting elements may include a second cathode, which is disposed between the thin-film encapsulation layer and the third via-insulating layer, and the second cathode may define an opening, which exposes the light-transmitting part.

In an embodiment, the thin-film encapsulation layer may include a first encapsulation inorganic layer, which is disposed on the second cathode, an encapsulation organic layer, which is disposed on the first encapsulation inorganic layer, and a second encapsulation inorganic layer, which is disposed on the encapsulation organic layer, and each of the first encapsulation inorganic layer, the encapsulation organic layer, and the second encapsulation inorganic layer may have a refractive index of about 1.5 to about 1.7.

According to another embodiment of the disclosure, a display device includes: a first display area including a first subpixel; and a second display area surrounded by the first display area and including a second subpixel and a light-transmitting part, where the light-transmitting part is adjacent to the second subpixel. The second display area has a smaller peak-to-valley (P-V) wavefront value than the first display area.

In an embodiment, the second display area may have a P-V wavefront value of about 2 $\mu$m.

In an embodiment, the second display area may have a root mean square ("RMS") wavefront value of about 0.4 or less.

According to the aforementioned and other embodiments of the disclosure, the MTF of a camera sensor can be improved.

In addition, the transmittance of an area that displays an image, and at the same time, transmits light therethrough can be improved.

It should be noted that the effects of the disclosure are not limited to those described above, and other effects of the disclosure will be apparent from the following description.

At least some of the above and other features of the invention are set out in the claims.

BRIEF DESCRIPTION OF THE DRAWINGS

The above and other aspects and features of the disclosure will become more apparent by describing in detail embodiments thereof with reference to the attached drawings, in which:

FIG. 1 is a perspective view of a display device according to an embodiment of the disclosure;
FIG. 2 is an exploded perspective view of the display device of FIG. 1;
FIG. 3 is a cross-sectional view illustrating the layout of a display panel and an image sensor of FIG. 1;
FIG. 4 is a conceptual diagram for explaining the haze of a material;
FIGS. 5 and 6 are conceptual diagrams for explaining the wavefront characteristic of a material;
FIG. 7 is a conceptual diagram for explaining the modulation transfer function (MTF) of an image sensor;
FIG. 8 is a plan view of a display panel according to an embodiment of the disclosure;
FIG. 9 is a circuit diagram of a subpixel of the display panel of FIG. 8;
FIG. 10 is a plan view illustrating the layout of first subpixels in a main display area of the display panel of FIG. 8;
FIG. 11 is a plan view illustrating the layout of a first cathode on first subpixels in the main display area of the display panel of FIG. 8;
FIG. 12 is a cross-sectional view taken along line X1-X1' of FIG. 11;
FIG. 13 is an enlarged cross-sectional view of an area A of FIG. 12;
FIG. 14 is a plan view illustrating the layout of first subpixels and second subpixels in a sub-display area of the display panel of FIG. 8;
FIG. 15 is a cross-sectional view taken along line X2-X2' of FIG. 14;
FIG. 16 is a cross-sectional view taken along line X3-X3' of FIG. 14;
FIG. 17 is a plan view illustrating the layout of a second cathode on second subpixels in a first sub-display area of the display panel of FIG. 8;
FIG. 18 is a cross-sectional view, taken along line X4-X4' of FIG. 17, for explaining the haze of each layer of the display panel of FIG. 8;
FIG. 19 is an enlarged cross-sectional view of an area B of FIG. 18;
FIG. 20 is a cross-sectional view, taken along line X4-X4' of FIG. 17, for explaining the haze of each layer of the display panel of FIG. 8 according to another embodiment;
FIG. 21 is an enlarged cross-sectional view of an area C of FIG. 20;
FIG. 22 is a cross-sectional view, taken along line X4-X4' of FIG. 17, for explaining the refractive index of each layer of the display panel of FIG. 8 according to still another embodiment;
FIG. 23 is an enlarged cross-sectional view of an area D of FIG. 22;
FIG. 24 is an enlarged cross-sectional view of an area E of FIG. 22;
FIG. 25 is a graph showing the variation of an extinction coefficient against a refractive index; and
FIG. 26 is a cross-sectional view of a first sub-display area of a display device according to another embodiment of the disclosure.

DETAILED DESCRIPTION

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10% or 5% of the stated value.

Features of each of various embodiments of the disclosure may be partially or entirely combined with each other and may technically variously interwork with each other, and respective embodiments may be implemented independently of each other or may be implemented together in association with each other.

Hereinafter, embodiments of the present invention will be described with reference to the attached drawing.

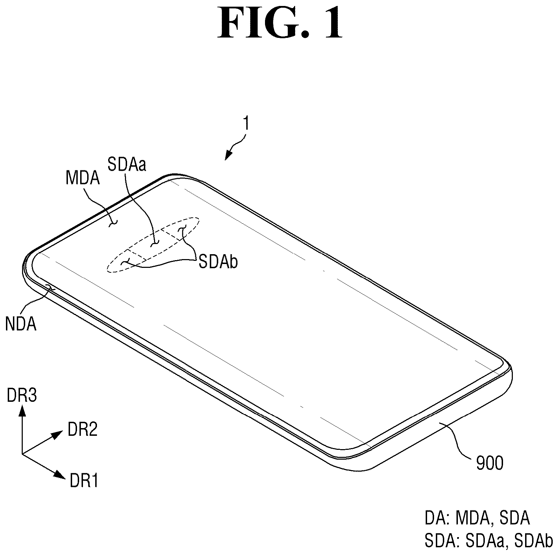

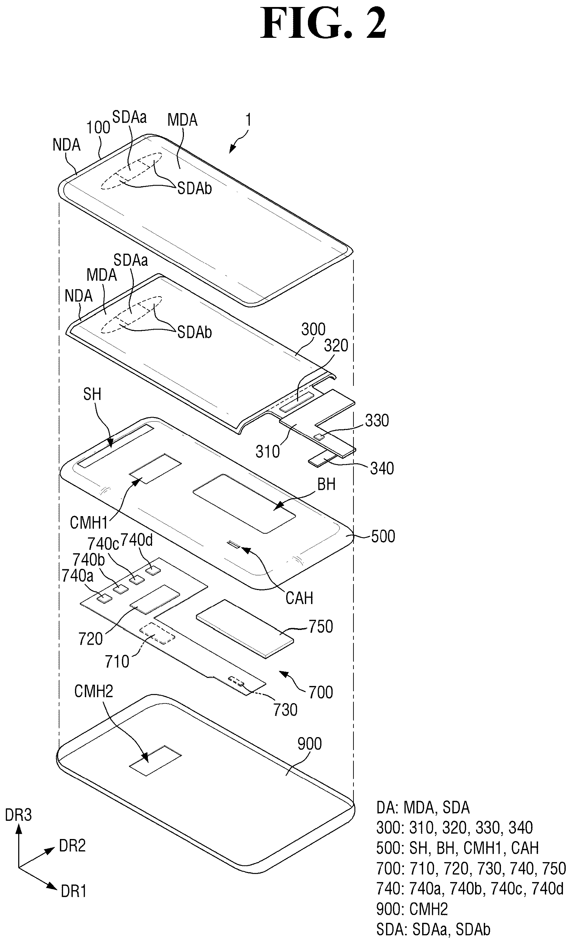

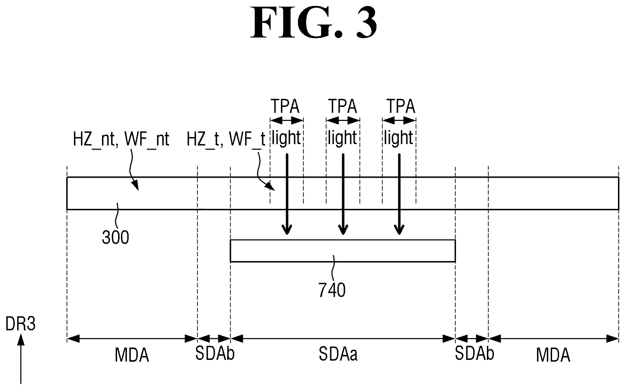

FIG. 1 is a perspective view of a display device according to an embodiment of the disclosure. FIG. 2 is an exploded perspective view of the display device of FIG. 1. FIG. 3 is a cross-sectional view illustrating the layout of a display panel and an image sensor of FIG. 1.

Referring to FIGS. 1 through 3, a display device 1 may be applicable to a portable electronic device such as a mobile phone, a smartphone, a tablet personal computer (PC), a mobile communication terminal, an electronic notepad, an electronic book reader, a portable multimedia player ("PMP"), a navigation device, or an ultramobile PC ("UMPC"). The display device 1 may also be applicable to a television (TV), a notebook computer, a monitor, an electronic billboard, or an Internet-of-Things ("IoT") device.

The display device 1 may have a three-dimensional ("3D") shape. For example, the display device 1 may have a cuboid shape or a 3D shape similar to a cuboid shape. A direction parallel to a first side of the display device 1 may be referred to as a first direction DR1, a direction parallel to a second side of the display device 1 may be referred to as a second direction DR2, and the thickness direction of the display device 1 may be referred to as a third direction DR3. Unless otherwise specified, a particular direction may refer to opposite sides in the particular direction. If there is the need to distinguish one side from the other side in the particular direction, one side in the particular direction may be referred to as a first side, and the other side in the particular direction may be referred to as a second side. Referring to FIG. 1, a direction indicated by an arrow may be referred to as a first side, and the opposite direction thereof may be referred to as a second side. The first and second directions DR1 and DR2 may be perpendicular to each other, the first and third directions DR1 and DR3 may be perpendicular to each other, and the second and third directions DR2 and DR3 may be perpendicular to each other.

The display device 1 may have a rectangular shape in a plan view. For example, as illustrated in FIG. 1, the display device 1 may have a rectangle-like shape having long sides in the first direction DR1 and short sides in the second direction DR2 in a plan view. As used herein, the "plan view" is a view in the third direction DR3. The corners at which the long sides and the short sides of the display device 1 meet may be rounded to have a predetermined curvature or may be formed at a right angle. The planar shape of the display device 1 according to the invention is not particularly limited. Alternately, the display device 1 may have a non-tetragonal polygonal shape, a circular shape, or an elliptical shape in a plan view.

The display device 1 may be flat or to have two opposite sides thereof bent, but the disclosure is not limited thereto. For example, the left and right sides of the display device 1 may be bent, or the upper, lower, left, and right sides of the display device 1 may all be bent in another embodiment.

One surface, in the third direction DR3, of the display device 1 may be the top surface of the display device 1, and an opposite surface, in the third direction DR3, of the display device 1 may be the bottom surface of the display device 1.

The display device 1 may include a display area DA, which displays an image, and a non-display area NDA, which does not display an image. The non-display area NDA may be disposed to surround the edges of the display area DA, but the disclosure is not limited thereto.

The display area DA may include a main display area MDA, which has a relatively high pixels-per-inch ("PPI"), and a sub-display area SDA, which has a relatively low PPI.

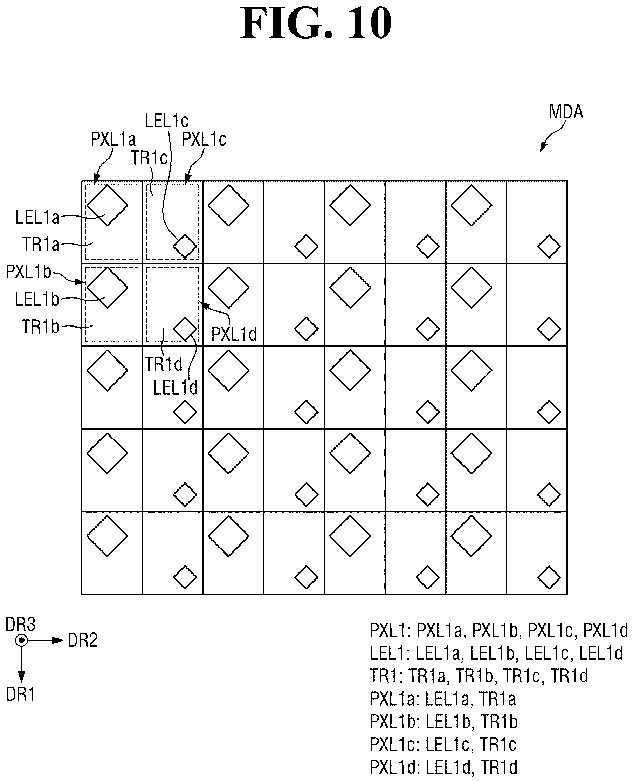

The main display area MDA may account for most of the display area DA. The main display area MDA may not include light-transmitting parts TPA, which transmit light therethrough (See FIG. 3). As will be described later, the main display area MDA may include first subpixels PXL1 (see e.g. FIG. 10), which are for displaying an image.

The sub-display area SDA may include a first sub-display area SDAa and a second sub-display area SDAb, which is disposed between the first sub-display area SDAa and the main display area MDA. The first sub-display area SDAa may include the light-transmitting parts TPA, which transmit light therethrough, and second sub-pixels PXL2, which are for displaying an image. Accordingly, the light transmittance of the first sub-display area SDAa may be higher than the light transmittance of the main display area MDA. As will be described later, the second sub-display area SDAb may include second thin-film transistors (TFTs) TR2 of the second subpixels PXL2. The main display area MDA may be referred to as a first display area, the first sub-display area SDAa may be referred to as a second display area, and the second sub-display area SDAb may be referred to as a third display area.

The sub-display area SDA may be disposed on the inside of the main display area MDA (i.e., completely surrounded by the main display area MDA in a plan view), but the disclosure is not limited thereto. Alternatively, the sub-display area SDA may be disposed on one side of the main display area MDA in another embodiment. The sub-display area SDA may have an elliptical shape, but the disclosure is not limited thereto. Alternatively, the sub-display area SDA may have a rectangular shape in still another embodiment. The second sub-display area SDAb may be disposed on opposite sides, in the second direction DR2, of the first sub-display area SDAa, but the disclosure is not limited thereto. In an embodiment, one sub-display area SDA may be provided, but the disclosure is not limited thereto. Alternatively, a plurality of sub-display areas SDA may be provided in another embodiment.

The main display area MDA, the first sub-display area SDAa, and the second sub-display area SDAb of the display device 10 may be directly applied to each of the elements of the display device 1 that will be described later. For example, part of a display panel 300 overlapping with the main display area MDA of the display device 1 in the third direction DR3 may become a main display area MDA of the display panel 300, part of the display panel 300 overlapping with the first sub-display area SDAa of the display device 1 in the third direction DR3 may become a first sub-display area SDAa of the display panel 300, and part of the display panel 300 overlapping with the second sub-display area SDAb of the display device 1 in the third direction DR3 may become a second sub-display area SDAb of the display panel 300.

The display device 1 may include a cover window 100, the display panel 300, a display circuit board 310, a display driving circuit 320, a bracket 500, a main circuit board 700, optical devices 740, and a lower cover 900.

The cover window 100 may protect the front surface of the display panel 300. The cover window 100 may be disposed above the display panel 300 to cover the top surface of the display panel 300.

The display panel 300 may include subpixels and may thus provide a screen to a user. The display panel 300 may be disposed below the cover window 100. The display panel 300 may be a light-emitting display panel including light-emitting elements. For example, the display panel 300 may be an organic light-emitting diode ("OLED") display panel using OLEDs including organic light-emitting layers, a micro-light-emitting diode ("microLED") display panel using microLEDs, a quantum-dot light-emitting diode display panel using quantum-dot light-emitting diodes, or an inorganic light-emitting diode display panel using inorganic light-emitting diodes. The display panel 300 will hereinafter be described as being an OLED display panel. The structure of the display panel 300 will be described later.

A surface, in the third direction DR3, of the display panel 300 where the cover window 100 is disposed may be the top surface of the display panel 300, and a surface, in the third direction DR3, of the display panel 300 where the bracket 500 is disposed may be the bottom surface of the display panel 300.

The display circuit board 310 and the display driving circuit 320 may be attached to a first side, in the first direction DR1, of the display panel 300. The display circuit board 310 may be a flexible printed circuit board ("FPCB") that is bendable, a rigid printed circuit board ("PCB") that is rigid and hardly bendable, or a hybrid PCB that has the characteristics of both a rigid PCB and an FPCB.

The display driving circuit 320 may receive control signals and power supply voltages via the display circuit board 310 and may generate and output signals and voltages for driving the display panel 300. The display driving circuit 320 may be formed as an integrated circuit ("IC") and may be attached to a subarea SBA of the display panel 300 in a chip-on-glass ("COG"), chip-on-plastic ("COP"), or ultrasonic manner, but the disclosure is not limited thereto. Alternatively, the display driving circuit 320 may be attached on the display circuit board 310 in another embodiment.

A touch driving circuit 330 may be disposed on the display circuit board 310. The touch driving circuit 330 may be formed as an IC and may be attached on the top surface of the display circuit board 310. The touch driving circuit 330 may be electrically connected to touch electrodes of a touch sensor layer TSL of the display panel 300 via the display circuit board 310. The touch driving circuit 330 may output touch driving signals to the touch electrodes and may sense voltages that the capacitors of the touch electrodes are charged with.

The touch driving circuit 330 may generate touch data based on variations in electric signals sensed by the touch electrodes and may transmit the touch data to a main processor 710, and the main processor 710 may calculate the touch coordinates of touch input by analyzing the touch data.

A power supply unit may be additionally provided to supply display driving voltages for driving the display driving circuit 320.

The bracket 500 may be disposed below the display panel 300.

The bracket 500 may couple the lower cover 900. A first camera hole CMH1, in which a first camera sensor 720 is inserted, a battery hole BH, in which a battery 750 is disposed, a cable hole CAH, through which a cable 314 connected to the display circuit board 310 passes, and a light-transmitting hole SH, in which the optical devices 740 are disposed, may be defined in the bracket 500. Alternatively, the bracket 500 may not include the light-transmitting hole SH and may not overlap with the first sub-display area SDAa of the display panel 300 in a plan view. The bracket 500 may be formed of plastic, a metal, or both.

The main circuit board 700 may be disposed below the bracket 500.

The main circuit board 700 may be a PCB or an FPCB. The main circuit board 700 may include the main processor 710, the first camera sensor 720, a main connector 730, the optical devices 740, and the battery 750. The optical devices 740 may include a proximity sensor 740a, an illumination sensor 740b, an iris sensor 740c, and a second camera sensor 740d.

The main processor 710 may output circuit signals for controlling all the functions of the display device 1. For example, the main processor 710 may control the display device 1 in accordance with sensor signals from the first camera sensor 720, the proximity sensor 740a, the illumination sensor 740b, the iris sensor 740c, and the second camera sensor 740d.

The first camera sensor 720 may be disposed on both the top and bottom surfaces of the main circuit board 700, the main processor 710 may be disposed on the top surface of the main circuit board 700, and the main connector 730 may be disposed on the bottom surface of the main circuit board 700. The proximity sensor 740a, the illumination sensor 740b, the iris sensor 740c, and the second camera sensor 740d may be disposed on the top surface of the main circuit board 700.

The first camera sensor 720 may process first image data such as a still or moving image of a second side, in the third direction DR3, of the display device 1, captured by an image sensor, and may output the processed first image data to the main processor 710. The first camera sensor 720 may be a complementary metal-oxide-semiconductor ("CMOS") image sensor or a charge-coupled device ("CCD") image sensor. The first camera sensor 720 may be exposed at the bottom of the lower cover 900 through a second camera hole CMH2 and may thus be able to capture an image of an object or the background below the display device 1.

The proximity sensor 740a may sense an object in the proximity of the top surface of the display device 1. The proximity sensor 740a may include a light source that outputs light and a light receiver that receives light reflected from an object. The proximity sensor 740a may determine the presence of an object in the proximity of the top surface of the display device 1 based on the amount of light reflected from the object. As the proximity sensor 740a is disposed to overlap, in the third direction DR3, with the light-transmitting hole SH and the first sub-display area SDAa of the display panel 300, the proximity sensor 740a can easily sense the presence of an object in the proximity of the top surface of the display device 1.

The illumination sensor 740b may sense the brightness of the top surface of the display device 1. The illumination sensor 740b may include a resistor whose resistance varies depending on the brightness of light incident thereupon. The illumination sensor 740b may determine the brightness of the top surface of the display device 1 based on the resistance of the resistor. As the illumination sensor 740b is disposed to overlap, in the third direction DR3, with the light-transmitting hole SH and the first sub-display area SDAa of the display panel 300, the illumination sensor 740b can easily sense the brightness of the top surface of the display device 1.

The iris sensor 740c may be a sensor for determining whether a captured iris image of the user is identical to an iris image stored in advance in a memory. As the iris sensor 740c is disposed to overlap, in the third direction DR3, with the light-transmitting hole SH and the first sub-display area SDAa of the display panel 300, the iris sensor 740c can easily capture an image of the iris of the user above the display device 10.

The second camera sensor 740d may process second image data such as a still or moving image of a first side, in the third direction DR3, of the display device 1, captured by an image sensor, and may output the processed second image data to the main processor 710. The second camera sensor 740d may be a CMOS image sensor or a CCD image sensor. The number of subpixels of the second camera sensor 740d may be less than the number of subpixels of the first camera sensor 720, and the size of the second camera sensor 740d may be smaller than the size of the first camera sensor 720. As the second camera sensor 740d is disposed to overlap, in the third direction DR3, with the light-transmitting hole SH and the first sub-display area SDAa of the display panel 300, the second camera sensor 740d can capture an image of an object or the background above the display device 1.

FIG. 2 illustrates that the first sub-display area SDA1 overlaps with all the proximity sensor 740a, the illumination sensor 740b, the iris sensor 740c, and the second camera sensor 740d in a plan view, but the disclosure is not limited thereto. For example, the number of first sub-display areas SDAa may be determined by the number of optical devices in another embodiment. In this example, a plurality of first sub-display areas SDAa may be disposed to correspond one-to-one to the proximity sensor 740a, the illumination sensor 740b, the iris sensor 740c, and the second camera sensor 740d. The optical devices 740 will hereinafter be described, taking the second camera sensor 740d as an example.

The cable 314, which passes through the cable hole CAH of the bracket 500, may be connected to the main connector 730. Accordingly, the main circuit board 700 may be electrically connected to the display circuit board 310.

The battery 750 may supply power to the display device 1. The battery 750 may overlap with the battery hole BH of the bracket 500 in a plan view.

The lower cover 900 may form the bottom exterior of the display device 1. The lower cover 900 may be disposed below the main circuit board 700 and the battery 750. The lower cover 900 may be coupled and fastened to the bracket 500. The lower cover 900 may be formed of plastic, a metal, or both.

The second camera hole CMH2, which exposes the bottom surface of the first camera sensor 720, may be formed in the lower cover 900.

Referring back to FIG. 3, the optical devices 740 may include the light-transmitting parts TPA, which transmit light therethrough, and may be disposed to overlap with the first sub-display area SDAa, which has a relatively high light transmittance. Thus, even though the optical devices 740 overlap with the display panel 300 in a plan view, the optical devices 740 can easily sense light incident thereupon from the top surface of the display device 1 through the first sub-display area SDAa. However, even if the optical devices 740 can sense light incident thereupon from the top surface of the display device 1, the optical devices 740 can only obtain a low-resolution image, if the optical characteristics (e.g., haze or wavefront characteristic) of the light-transmitting parts TPA are poor. In other words, in order to obtain a high-resolution image, not only the light transmittance of the light-transmitting parts TPA, but also the haze or wavefront characteristics of the light-transmitting parts TPA are desirable to be considered.

Values of the haze HZ_t and wavefront characteristics WF_t of the light-transmitting parts TPA, which are disposed in the first sub-display area SDAa of the display panel 300, may be less than values of the haze HZ_nt and the wavefront characteristic WF_nt of the main display area MDA. Accordingly, the modulation transfer function (MTF) of the optical devices can be improved.

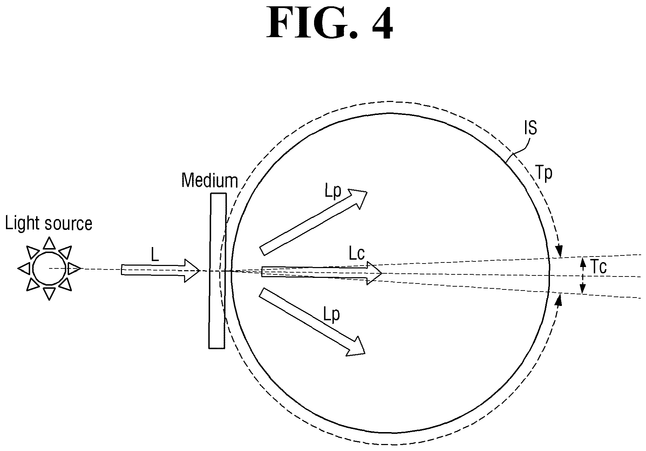

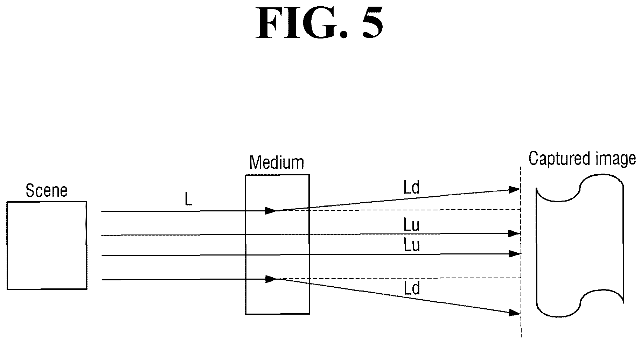

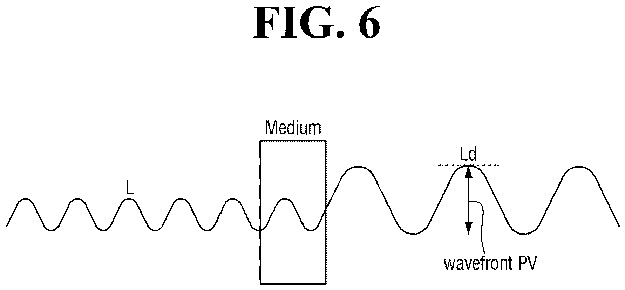

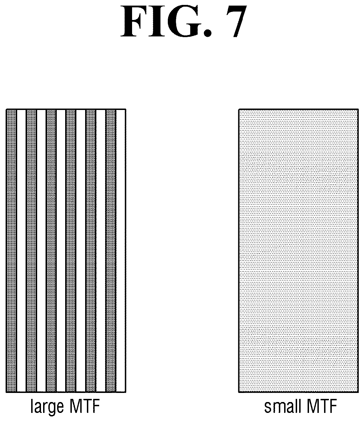

FIG. 4 is a conceptual diagram for explaining the haze of a material. FIGS. 5 and 6 are conceptual diagrams for explaining the wavefront characteristic of a material. FIG. 7 is a conceptual diagram for explaining the modulation transfer function (MTF) of an image sensor.

Referring to FIG. 4, light incident upon a material from a light source may spread through the material. The haze of the material may refer to the degree to which light transmitted through the material spreads due to the inherent properties of the material. In other words, the haze of the material may refer to the degree to which light incident upon the material scatters.

The haze of the material may be measured using an integrated sphere (IS), as indicated by Equation (1):

$$HZ\,(\%) = T\_p/(T\_p + T\_c) \times 100 \qquad \ldots(1)$$

where $T\_p$ denotes the intensity of light transmitted through the IS at an angle of 2.5 degrees (°) or greater, i.e., the intensity of diffused light, $T\_c$ denotes the intensity of light transmitted through the IS at an angle of 2.5° or less, i.e., the intensity of parallel light. Thus, the greater the haze of the material, the more the light transmitted through the material scatters, and the less the haze of the material, the less the light transmitted through the material scatters.

Referring to FIGS. 5 and 6, as light reflected from a subject passes through a material, the path of the light is distorted so that the amplitude of the light changes. As a result, the subject may appear distorted. The wavefront characteristic of the material may refer to the degree to which light transmitted through the material is distorted. The wavefront characteristic of the material may be measured as a peak-to-valley (P-V) wavefront value or as a root mean square (RMS) wavefront value, which is the average of P-V wavefront values.

For example, the P-V wavefront value of the material may refer to the maximum difference between the peak wavelength and the valley wavelength of distorted light. The P-V wavefront value of the material may vary depending on the location or the degree of distortion of light. The greater the P-V wavefront value, the more distorted the light transmitted through the material. Meanwhile, in the disclosure, a light emitted by the display device 1 according to an embodiment may have a wavelength band of approximately 380 nm to 780 nm, that is, a visible light wavelength band.

The RMS wavefront value of the material may refer to the average of P-V wavefront values of the material that differ from one another for different locations. The greater the RMS wavefront value, the greater the difference between P-V wavefront values for different locations, and the less the RMS wavefront value, the less the difference between P-V wavefront values for different locations.

The expression "high wavefront characteristic", as used herein, may mean a high P-V or RMS wavefront value, and the expression "low wavefront characteristic", as used herein may mean a low P-V or RMS wavefront value.

Referring to FIG. 7, an image containing a series of alternating black and white bars may appear vivid with sharp line edges when MTF is high and may appear gray with blurred line edges when MTF is low.

MTF may be expressed by Equation (2):

$$MTF\,(\%) = (I\_max - I\_min)/(I\_max + I\_min) \times 100 \qquad \ldots(2)$$

where *Imax* denotes maximum light intensity measured and *Imin* denotes minimum light intensity measured. As the black bars absorb light, ideal minimum light intensity may be 0. As the white bars reflect light, ideal maximum light intensity may be 1.

MTF may vary depending on the number of black bars and white bars per unit length. The number of black bars and white bars per unit length, i.e., spatial frequency, may be expressed as line pairs per millimeter (lp/mm). The spatial frequency of the image of FIG. 7 may be 6 lp/mm. For the same camera performance, the higher the spatial frequency, the lower the MTF.

MTF is affected not only by spatial frequency, but also haze and wavefront characteristics. For example, the lower the haze, the higher the MTF, and the greater the P-V wavefront value (or the less the RMS wavefront value), the higher the MTF.

Generally, a camera sensor is desirable to have an MTF of 50% or greater at 110 lp/mm. Accordingly, when spatial frequency is fixed at 110 lp/mm, the haze and the wavefront characteristic of the display panel 300, particularly, the haze and the wavefront characteristic of the first sub-display area SDAa of the display panel 300, are desirable to be controlled to achieve an MTF of 50% or greater. Specifically, the haze and the wavefront characteristic of an optical characteristics-control organic layer 200 in the first sub-display area SDAa are desirable to be controlled. A structure capable of improving the MTF of the optical devices by controlling the haze and the wavefront characteristic of the display panel 300 will hereinafter be described.

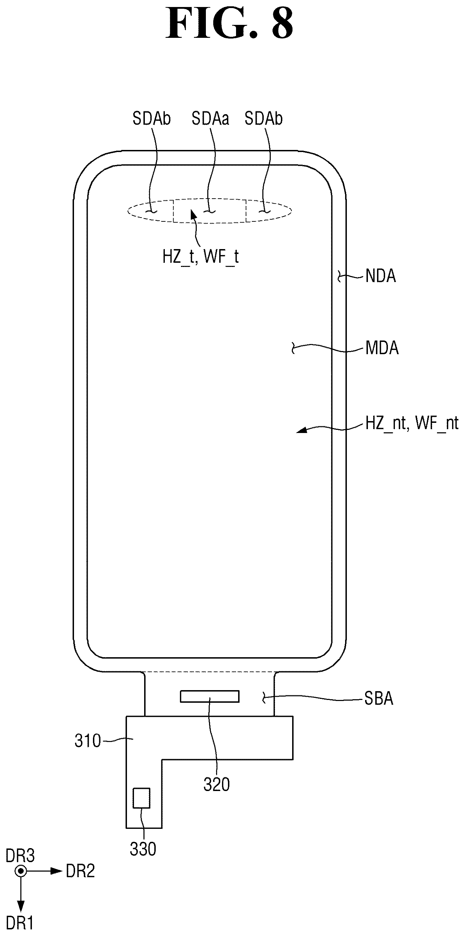

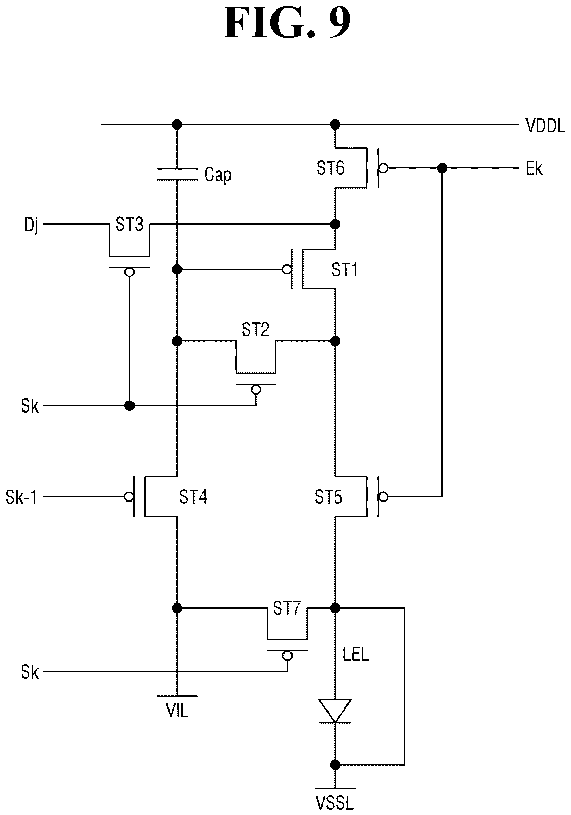

FIG. 8 is a plan view of a display panel according to an embodiment of the disclosure. FIG. 9 is a circuit diagram of a subpixel of the display panel of FIG. 8.

Referring to FIG. 8, a display panel 300 may include a main display area MDA, a first sub-display area SDAa, a second sub-display area SDAb, and a non-display area NDA. The main display area MDA, the first sub-display area SDAa, the second sub-display area SDAb, and the non-display area NDA may be the same as their respective counterparts of FIG. 2, and thus, detailed descriptions thereof will be omitted.

The values of the haze and the wavefront characteristic of the main display area MDA of the display panel 300 may be greater than values of the haze and the wavefront characteristic of the first sub-display area SDA of the display panel 300.

Referring to FIG. 9, a subpixel disposed in a display area DA of the display panel 300 may be connected to a (k-1)-th scan line Sk-1, a k-th scan line Sk, and a j-th data line Dj (where k and j are natural numbers of 1 or greater). Also, the subpixel may be connected to a first driving voltage line VDDL, to which a first driving voltage is supplied, an initialization voltage line VIL, to which an initialization voltage is supplied, and a second driving voltage line VSSL, to which a second driving voltage that is lower than the first driving voltage is supplied. The subpixel may be classified into a first subpixel PXL1, which is disposed in the main display area MDA, or a second subpixel PXL2, which is disposed in a first sub-display area SDAa.

The subpixel may include a thin-film transistor (TFT) and a light-emitting element LEL. The TFT may include a driving transistor DT and switching transistors SW. The driving transistor DT may receive the first or second driving voltage and may provide a driving current to the light-emitting element LEL, and the switching transistors SW may transmit data signals to the driving transistor DT.

The driving transistor DT may include a first transistor ST1, and the switching transistors SW may include second through seventh transistors ST2 through ST7. That is, the TFT may be construed as including a plurality of transistors. The light-emitting element LEL may include a first electrode, a second electrode, and an emission layer.

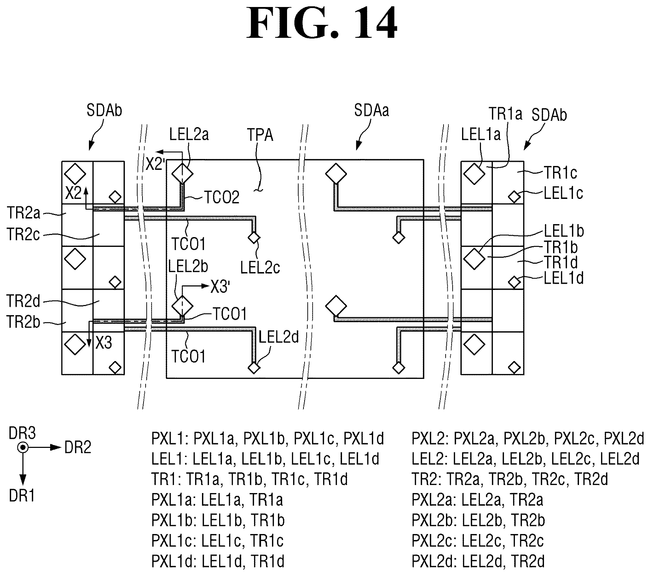

As will be described later, the first subpixel PXL1 may include a first TFT TR1, which is disposed in the main display area MDA or the second sub-display area SDAb, and a first light-emitting element LEL1, which is disposed on the first TFT TR1, as illustrated in FIGS. 10 and 14, and the second subpixel PXL2 may include a second TFT TR2, which is disposed in the second sub-display area SDAb, and a second light-emitting element LEL2, which is disposed in the first sub-display area SDAa, as illustrated in FIG. 14. In this case, the first and second TFTs TR1 and TR2 may include the first through seventh transistors ST1 through ST7.

The first transistor ST1 may include a first gate electrode, a first semiconductor active region, a first electrode, and a second electrode. The first transistor ST1 may control a drain-source current flowing between the first electrode and the second electrode, in accordance with a data voltage applied to the first gate electrode. A driving current flowing through the channel of the first transistor ST1 may be proportional to the square of the difference between a threshold voltage and the voltage between the first gate electrode and the first electrode of the first transistor ST1, as indicated by Equation (3):

$$Ids = k' \times (Vgs - Vth)^2 \qquad ...(3)$$

where *k'* denotes a proportionality coefficient determined by the structure and physical characteristics of the first transistor ST1, *Vgs* denotes the gate-source voltage of the first transistor ST1, *Vth* denotes the threshold voltage of the first transistor ST1, and *Ids* denotes the driving current of the first transistor ST1.

The light-emitting element LEL may emit light in accordance with the driving current. The amount of light emitted by the light-emitting element LEL may be proportional to the driving current. The light-emitting element LEL may include the first electrode, the second electrode, and the emission layer disposed between the first electrode and the second electrode. The first electrode may be an anode, and the second electrode may be a cathode. The light-emitting element LEL may be classified into a first light-emitting element LEL1, which is disposed in the main display area MDA or the second sub-display area SDAb, and a second light-emitting element LEL2, which is disposed in the first sub-display area SDAa.

The first electrode of the light-emitting element LEL may be connected to the first electrode of the seventh transistor ST7 and the second electrode of the fifth transistor ST5, and the second electrode of the light-emitting element LEL may be connected to the second driving voltage line VSSL.

The second transistor ST2 may is turned on by a scan signal from the k-th scan line Sk to connect the first gate electrode and the second electrode of the first transistor ST1. That is, in a case where the second transistor ST2 is turned on, the first transistor ST1 operates as a diode because the first gate electrode and the second electrode of the first transistor ST1 are connected. The second transistor ST2 may include a second gate electrode, a second semiconductor active region, a first electrode, and a second electrode. The second gate electrode of the second transistor ST2 may be connected to the k-th scan line Sk, the first electrode of the second transistor ST2 may be connected to the second electrode of the first transistor ST1, and the second electrode of the second transistor ST2 may be connected to the first gate electrode of the first transistor ST1.

The third transistor ST3 is turned on by the scan signal from the k-th scan line Sk to connect the first electrode of the first transistor ST1 and the j-th data line Dj. The third transistor ST3 may include a third gate electrode, a third semiconductor active region, a first electrode, and a second electrode. The third gate electrode of the third transistor ST3 may be connected to the k-th scan line Sk, the first electrode of the third transistor ST3 may be connected to the first electrode of the first transistor ST1, and the second electrode of the third transistor ST3 may be connected to the j-th data line Dj.

The fourth transistor ST4 is turned on by the scan signal from the (k-1)-th scan line Sk-1 to connect the first gate electrode of the first transistor ST1 and the initialization voltage line VIL. The first gate electrode of the first transistor ST1 may be discharged to as low as the initialization voltage of the initialization voltage line VIL. The fourth transistor ST4 may include a fourth gate electrode, a fourth semiconductor active region, a first electrode, and a second electrode. The fourth gate electrode of the fourth transistor ST4 may be connected to the (k-1)-th scan line Sk-1, the first electrode of the fourth transistor ST4 may be connected to the first gate of the first transistor ST1, and the second electrode of the fourth transistor ST4 may be connected to the initialization voltage line VIL.

The fifth transistor is connected between the second electrode of the first transistor ST1 and the first electrode of the light-emitting element LEL. The fifth transistor ST5 is turned on by an emission control signal from a k-th emission line Ek to connect the second electrode of the first transistor ST1 and the first electrode of the light-emitting element LEL. The fifth transistor ST5 may include a fifth gate electrode, a fifth semiconductor active region, a first electrode, and a second electrode. The fifth gate electrode of the fifth transistor ST5 may be connected to the k-th emission line Ek, the first electrode of the fifth transistor ST5 may be connected to the second electrode of the first transistor ST1, and the second electrode of the fifth transistor ST5 may be connected to the first electrode of the light-emitting element LEL.

The sixth transistor ST6 is turned on by the emission control signal from the k-th emission line Ek to connect the first electrode of the first transistor ST1 and the first driving voltage line VDDL. The sixth transistor ST6 may include a sixth gate electrode, a sixth semiconductor active region, a first electrode, and a second electrode. The sixth gate electrode of the sixth transistor ST6 may be connected to the k-th emission line Ek, the first electrode of the sixth transistor ST6 may be connected to the first driving voltage line VDDL, and the second electrode of the transistor ST6 may be connected to the first electrode of the first transistor ST1. In a case where the fifth and sixth transistors ST5 and ST6 are both turned on, the driving current may be provided to the light-emitting device LEL.

The seventh transistor ST7 is turned on by the scan signal from the k-th scan line Sk to connect the first electrode of the light-emitting element LEL and the initialization voltage line VIL. The first electrode of the light-emitting element LEL may be discharged to as low as the initialization voltage. The seventh transistor ST7 may include a seventh gate electrode, a seventh semiconductor active region, a first electrode, and a second electrode. The seventh gate electrode of the seventh transistor ST7 may be connected to the k-th scan line Sk, the first electrode of the seventh transistor ST7 may be connected to the first electrode of the light-emitting element LEL, and the second electrode of the seventh transistor ST7 may be connected to the initialization voltage line VIL.

The subpixel may further include a capacitor Cap. The capacitor Cap is formed between the first gate electrode of the first transistor ST1 and the first driving voltage line VDDL. A first electrode of the capacitor Cap may be connected to the first gate electrode of the first transistor ST1, and a second electrode of the capacitor Cap may be connected to the first driving voltage line VDDL.

In a case where the first electrodes of the first through seventh transistors ST1 through ST7 are source electrodes, the second electrodes of the first through seventh transistors ST1 through ST7 may be drain electrodes. Alternatively, in a case where the first electrodes of the first through seventh transistors ST1 through ST7 are drain electrodes, the second electrodes of the first through seventh transistors ST1 through ST7 may be source electrodes.

Each of the first through seventh transistors ST1 through ST7 may include a semiconductor active region. Each of the first through seventh transistors ST1 through ST7 may include a semiconductor active region formed of polycrystalline silicon, but the disclosure is not limited thereto.

In a case where the semiconductor active regions of the first through seventh transistors ST1 through ST7 are formed of polycrystalline silicon, the semiconductor active regions of the first through seventh transistors ST1 through ST7 may be formed by a low-temperature polycrystalline silicon process. FIG. 9 illustrates that the first through seventh transistors ST1 through ST7 are formed as p-type transistors, but the disclosure is not limited thereto. Alternatively, some or all of the first through seventh transistors ST1 through ST7 may be formed as n-type transistors in another embodiment.

The structure of the main display area MDA of the display panel 300 will hereinafter be described.

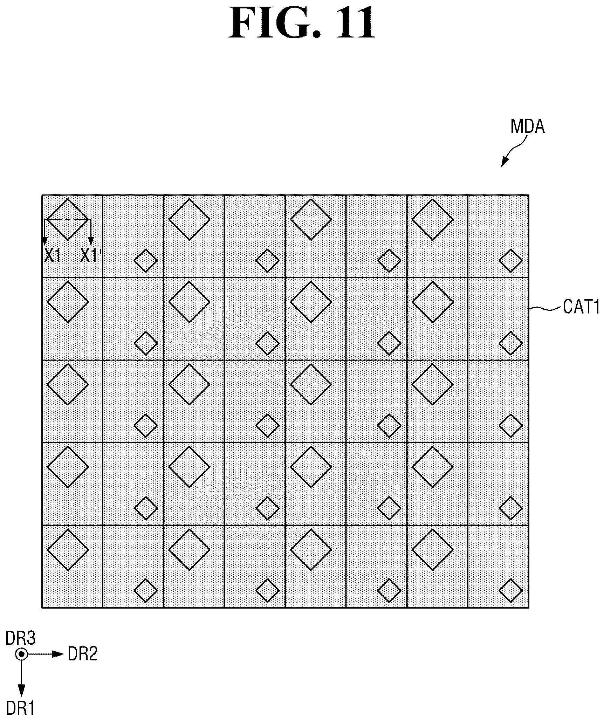

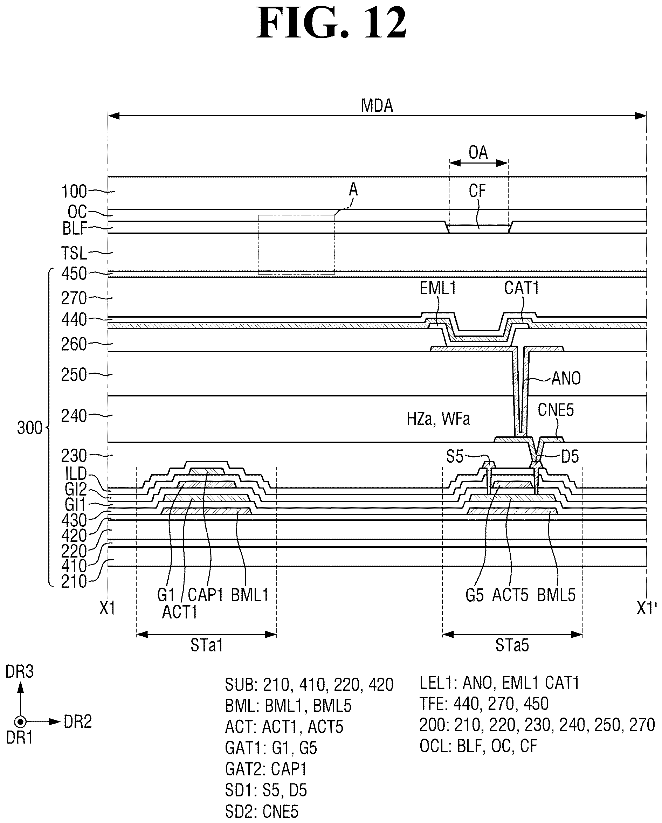

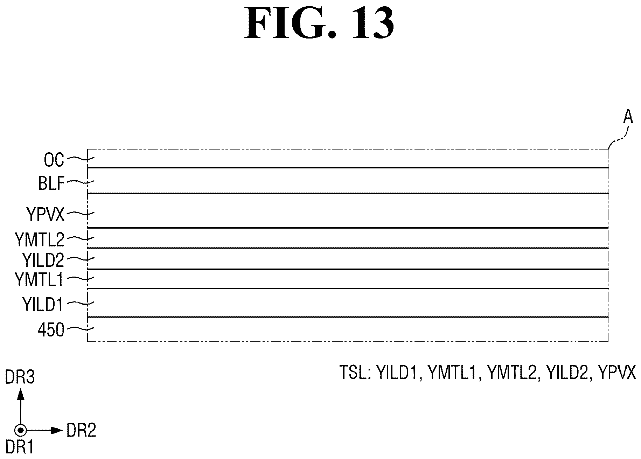

FIG. 10 is a plan view illustrating the layout of first subpixels in the main display area of the display panel of FIG. 8. FIG. 11 is a plan view illustrating the layout of a first cathode on first subpixels in the main display area of the display panel of FIG. 8. FIG. 12 is a cross-sectional view taken along line X1-X1' of FIG. 11. FIG. 13 is an enlarged cross-sectional view of an area A of FIG. 12.

Referring to FIG. 10, each of first subpixels PXL1, which are disposed in the main display area MDA, may include a first TFT TR1 and a first light-emitting element LEL1. The first light-emitting element LEL1 may be disposed on the first TFT TR1 and may be electrically connected to the first TFT TR1. In other words, the first light-emitting element LEL1 may overlap with the first TFT TR1 in the third direction DR3.

The first subpixels PXL1 may be classified into (1_1)-th subpixels PXL1a, (1_2)-th subpixels PXL1b, (1_3)-th subpixels PXL1c, and (1_4)-th subpixels PXL1d depending on their locations. (1_1)-th, (1_2)-th, (1_3)-th, and (1_4)-th subpixels PXL1a, PXL1b, PXL1c, and PXL1d may gather together to form a pixel capable of displaying white light. A first subpixel PXL1 on a second side, in the first direction DR1, and a second side, in the second direction DR2, of the center of the pixel may be the (1-1)-th subpixel PXL1a, a first subpixel PXL1 on the second side, in the first direction DR1, and a first side, in the second direction DR2, of the center of the pixel may be the (1_2)-th subpixel PXL1b, a first subpixel PXL1 on a first side, in the first direction DR1, and the first side, in the second direction DR2, of the center of the pixel may be the (1_3)-th subpixel PXL1c, and a first subpixel PXL1 on the first side, in the first direction DR1, and the second side, in the second direction DR2, of the center of the pixel may be the (1_4)-th subpixel PXL1d. Accordingly, first TFTs TR1 may be classified into (1_1)-th, (1_2)-th, (1_3)-th, and (1_4)-th TFTs TR1a, TR1b, TR1c, and TR1d, and first light-emitting elements LEL1 may be classified into (1_1)-th, (1_2)-th, (1_3)-th, and (1_4)-th light-emitting elements LEL1a, LEL1b, LEL1c, and LEL1d.

The (1_1)-th subpixel PXL1a may include the (1_1)-th TFT TR1a and the (1_1)-th light-emitting element LEL1a, the (1_2)-th subpixel PXL1b may include the (1_2)-th TFT TR1b and the (1_2)-th light-emitting element LEL1b, the (1_3)-th subpixel PXL1c may include the (1_3)-th TFT TR1c and the (1_3)-th light-emitting element LEL1c, and the (1_4)-th subpixel PXL1d may include the (1_4)-th TFT TR1d and the (1_4)-th light-emitting element LEL1d. The (1_1)-th light-emitting element LEL1a may be disposed on the (1_1)-th TFT TR1a and may be electrically connected to the (1_1)-th TFT TR1a, the (1_2)-th light-emitting element LEL1b may be disposed on the (1_2)-th TFT TR1b and may be electrically connected to the (1_2)-th TFT TR1b, the (1_3)-th light-emitting element LEL1c may be disposed on the (1_3)-th TFT TR1c and may be electrically connected to the (1_3)-th TFT TR1c, and the (1_4)-th light-emitting element LEL1d may be disposed on the (1_4)-th TFT TR1d and may be electrically connected to the (1_4)-th TFT TR1d. In other words, the (1_1)-th light-emitting element LEL1a may overlap with the (1_1)-th TFT TR1a in the third direction DR3, the (1_2)-th light-emitting element LEL1b may overlap with the (1_2)-th TFT TR1b in the third direction DR3, the (1_3)-th light-emitting element LEL1c may overlap with the (1_3)-th TFT TR1c in the third direction DR3, and the (1_4)-th light-emitting element LEL1d may overlap with the (1_4)-th TFT TR1d in the third direction DR3.

The (1_1)-th, (1_2)-th, (1_3)-th, and (1_4)-th subpixels PXL1a, PXL1b, PXL1c, and PXL1d may emit light of different colors, but the disclosure is not limited thereto. Alternatively, the (1_1)-th subpixel PXL1a may display blue light, the (1_2)-th subpixel PXL1b may display red light, and the (1_3)-th and (1_4)-th subpixels PXL1c and PXL1d may display green light in another embodiment. The first light-emitting elements LEL1 may have a rhombus shape in a plan view, but the disclosure is not limited thereto. Alternatively, the first light-emitting elements LEL1 may have a circular or rectangular shape in a plan view in another embodiment. The (1_1)-th and (1_2)-th light-emitting elements LEL1a and LEL1b may have a larger size than the (1_3)-th and (1_4)-th light-emitting elements LEL1c and LEL1d, but the disclosure is not limited thereto.

Only the first subpixels PXL1 may be disposed in the main display area MDA without any light-transmitting parts TPA therebetween. In other words, the layout of the (1_1)-th, (1_2)-th, (1_3)-th, and (1_4)-th subpixels PXL1a, PXL1b, PXL1c, and PXL1d may be repeated in the main display area MDA without any gaps therebetween.

Referring to FIG. 11, a first cathode CAT1 may be disposed in the main display area MDA to generally cover the main display area MDA. Although not specifically illustrated, the first cathode CAT1 may have substantially the same shape as the main display area MDA of the display panel 300 in a plan view. The first cathode CAT1 may not overlap with the first sub-display area SDAa in a plan view.

Referring to FIGS. 12 and 13, in the main display area MDA, the display panel 300 may have a structure in which a substate SUB, a lower metal layer BML, a buffer layer 430, a semiconductor layer ACT, a first gate insulating layer GI1, a first gate conductive layer GAT1, a second gate insulating layer GI2, a second gate conductive layer GAT2, an interlayer insulating layer ILD, a first metal conductive layer SD1, a first via-insulating layer 230, a second metal conductive layer SD2, a second via-insulating layer 240, a third via-insulating layer 250, a pixel-defining film 260, a first light-emitting element LEL1, and a thin-film encapsulation layer TFE are sequentially stacked in the third direction DR3. For convenience, FIGS. 12 and 13 illustrate only first and fifth transistors STal and STa5 of a first TFT TR1.

The main display area MDA, the first sub-display area SDAa, and the second sub-display area SDAb of the display panel 300 may be directly applicable to each of the elements of the display panel 300. For example, part of the substrate SUB overlapping with the main display area MDA of the display panel 300 in the third direction DR3 may become a main display area MDA of the substrate SUB, part of the substrate SUB overlapping with the first sub-display area SDAa of the display panel 300 in the third direction DR3 may become a first sub-display area SDAa of the substrate SUB, and part of the substrate SUB overlapping with the second sub-display area SDAb of the display panel 300 in the third direction DR3 may become a second sub-display area SDAb of the substrate SUB.

The substrate SUB may form the base of the display panel 300. The substrate SUB may be a flexible substrate including polyimide, but the disclosure is not limited thereto. Alternatively, the substrate SUB may be a rigid substrate including glass, but the disclosure is not limited thereto. For convenience, the substrate SUB will hereinafter be described as being a flexible substrate including polyimide.

The substrate SUB may include a first substrate layer 210, a first barrier layer 410, which is on the first substrate layer 210, a second substrate layer 220, which is on the first barrier layer 410, and a second barrier layer 420, which is on the second substrate layer 220.

The first and second substrate layers 210 and 220 may include an organic material such as a polyimide resin, and the first and second barrier layers 410 and 420 may include an inorganic insulating material such as silicon oxynitride ($SiO_xN_y$). However, the disclosure is not limited to this.

The lower metal layer BML may control the channel region of each semiconductor active region of the semiconductor layer ACT, prevent the penetration of light into each semiconductor region, or prevent damage caused by an electrostatic discharge together with the first gate conductive layer GAT1. The lower metal layer BML may be disposed on the second barrier layer 420 of the substrate SUB. The lower metal layer BML may include first and fifth lower metal layers BML1 and BML5, which overlap with first and fifth gate electrodes G1 and G5, respectively, that will be described later.

The lower metal layer BML may include a metal. For example, the lower metal layer BML may include at least one metal selected from among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu), but the disclosure is not limited thereto. Alternatively, the lower metal layer BML may include a light-blocking pigment such as carbon black, but the disclosure is not limited thereto. The lower metal layer BML may not be provided.

The buffer layer 430 may prevent the diffusion of metal atoms or impurities from the substrate SUB into the semiconductor layer ACT. The buffer layer 430 may be disposed on the entire substrate SUB. The buffer layer 430 may include an inorganic insulating material such as $SiO_xN_y$.

The semiconductor layer ACT may include, in the main display area MDA, semiconductor active regions of the first transistor STa1, second transistor, third transistor, fourth transistor and fifth transistor STa5 of the first TFT TR1. For example, as illustrated in FIG. 12, the first transistor STal may include a first semiconductor active region ACT1, and the fifth transistor STa5 may include a fifth semiconductor active region ACT5.

The first semiconductor active region ACT1 may include a first channel region overlapping with the first gate electrode G1, a first drain region disposed on one side of the first channel region, and a first source region disposed on the other side of the first channel region, and the fifth semiconductor active region ACT5 may include a fifth channel region overlapping with the fifth gate electrode G5 in a plan view, a fifth drain region disposed on one side of the fifth channel region, and a fifth source region disposed on the other side of the fifth channel region.

The semiconductor layer ACT may be disposed directly above a surface of the buffer layer 430. That is, the semiconductor layer ACT may be in direct contact with the surface of the buffer layer 430. The semiconductor layer ACT may be selectively patterned on the buffer layer 430. The semiconductor layer ACT may include polycrystalline silicon, but the disclosure is not limited thereto. For example, the semiconductor layer ACT may include amorphous silicon or an oxide semiconductor in another embodiment.

The first gate insulating layer GI1 may insulate the semiconductor layer ACT from a first conductive layer that will be described later. The first gate insulating layer GI1 may be disposed on the buffer layer 430 where the semiconductor layer ACT is disposed, to cover the semiconductor layer ACT. The first gate insulating layer GI1 may be disposed along the profile of the semiconductor layer ACT. The first gate insulating layer GI1 may include an inorganic insulating material such as $SiO_xN_y$.

The first conductive layer may be disposed on the first gate insulating layer GI1. The first conductive layer may be disposed directly above a surface of the first gate insulating layer GI1. That is, the first conductive layer may be disposed in direct contact with the surface of the first gate insulating layer GI1.

The first gate conductive layer GAT1 may include gate electrodes of the first and fifth transistors STal and STa5, which are disposed in the main display area MDA. For example, as illustrated in FIG. 12, the first gate conductive layer GAT1 may include a first gate electrode G1 of the first transistor STal and a fifth gate electrode G5 of the fifth transistor STa5. As already mentioned above, the first gate electrode G1 may overlap with the first channel region of the first semiconductor active region ACT1 in the third direction DR3, and the fifth gate electrode G5 may overlap with the fifth channel region of the fifth semiconductor active region ACT5 in the third direction DR3.

The first gate conductive layer GAT1 may include a metal. For example, the first gate conductive layer GAT1 may include at least one metal selected from among Mo, Al, Pt, Pd, Ag, Mg, Au, Ni, Nd, Ir, Cr, Ca, Ti, Ta, W, and Cu.

The second gate insulating layer GI2 may insulate the first gate conductive layer GAT1 from the second gate conductive layer GAT2. The second gate insulating layer GI2 may be disposed on the first gate insulating layer GI1 where the first gate conductive layer GAT1 is disposed, to cover the first gate conductive layer GAT1. The second gate insulating layer GI2 may be disposed to have substantially the same thickness along the profile of the first gate conductive layer GAT1. The second gate insulating layer GI2 may include an inorganic insulating material such as $SiO_xN_y$.

The second gate conductive layer GAT2 may be disposed on the second gate insulating layer GI2. The second gate conductive layer GAT2 may be disposed directly above a surface of the second gate insulating layer GI2. That is, the second gate conductive layer GAT2 may be in direct contact with the surface of the second gate insulating layer GI2.

The second gate conductive layer GAT2 may include a first capacitor electrode, which is disposed in the display area DA. For example, the second gate conductive layer GAT2 may include a first capacitor electrode CAP1 of the first TFT TR1. The same voltage as that applied to the first driving voltage line VDDL of FIG. 9 may be applied to the first capacitor electrode CAP1. The first capacitor electrode CAP1 may form the capacitor Cap of FIG. 9 together with the first and second gate insulating layers GI1 and GI2. The first capacitor electrode CAP1 may overlap with the first gate electrode G1 in the third direction DR3.

The second gate conductive layer GAT2 may include a metal. For example, the second gate conductive layer GAT2 may include at least one metal selected from among Mo, Al, Pt, Pd, Ag, Mg, Au, Ni, Nd, Ir, Cr, Ca, Ti, Ta, W, and Cu.

The interlayer insulating layer ILD may insulate the second gate conductive layer GAT2 from the first metal conductive layer SD1. The interlayer insulating layer ILD may be dispose don the second gate insulating layer GI2 where the second gate conductive layer GAT2 is formed. The interlayer insulating layer ILD may include an inorganic insulating material such as $SiO_xN_y$.

The first metal conductive layer SD1 may be disposed on the interlayer insulating layer ILD. The first metal conductive layer SD1 may include source and drain electrodes of the first transistor STal and source and drain electrodes of the fifth transistor STa5. For example, as illustrated in FIG. 5, the first metal conductive layer SD1 may include fifth source and drain electrodes S5 and D5 of the fifth transistor STa5.

Once the first metal conductive layer SD1, which includes the fifth source and drain electrodes S5 and D5 of the first transistor STal and the source and drain electrodes of the fifth transistor STa5, is formed on the interlayer insulating layer ILD, the first and fifth transistors STal and STa5 may be defined. The fifth source and drain electrodes S5 and D5 may be electrically connected to fifth source/drain regions of a fifth semiconductor pattern through contact holes that are formed to penetrate the interlayer insulating layer ILD, the second gate insulating layer GI2, and the first gate insulating layer GI1.

The first metal conductive layer SD1 may include a metal. For example, the first metal conductive layer SD1 may include at least one metal selected from among Mo, Al, Pt, Pd, Ag, Mg, Au, Ni, Nd, Ir, Cr, Ca, Ti, Ta, W, and Cu. The first metal conductive layer SD1 may have a multilayer structure. For example, the first metal conductive layer SD1 may have a double-layer structure of Ti/Al or a triple-layer structure of Ti/Al/Ti.

The first via-insulating layer 230 may insulate the first metal conductive layer SD1 from the second metal conductive layer SD2 and may planarize a height difference formed by the first TFT TR1. The first via-insulating layer 230 may be disposed on the interlayer insulating layer ILD where the first metal conducive layer SD1 is formed. The first via-insulating layer 230 may be formed of an organic insulating material such as an acrylic resin, a polyimide resin, or a polyamide resin.

The second metal conductive layer SD2 may be disposed on the first via-insulating layer 230. The second metal conductive layer SD2 may include connecting electrodes, which are electrically connected to the fifth source and drain electrodes S5 and D5 of the first transistor STal and the source and drain electrodes of the fifth transistor STa5, and an initialization voltage line. For example, as illustrated in FIG. 12, the second metal conductive layer SD2 may include a fifth connecting electrode CNE5, which is electrically connected to the fifth drain electrode D5. The fifth connecting electrode CNE5 may be electrically connected to the fifth drain electrode D5 through a contact hole that is formed to penetrate the first via-insulating layer 230.

The second metal conductive layer SD2 may include a metal. For example, the second metal conductive layer SD2 may include at least one metal selected from among Mo, Al, Pt, Pd, Ag, Mg, Au, Ni, Nd, Ir, Cr, Ca, Ti, Ta, W, and Cu. The second metal conductive layer SD2 may have a multilayer structure. For example, the second metal conductive layer SD2 may have a double-layer structure of Ti/Al or a triple-layer structure of Ti/Al/Ti.

The second via-insulating layer 240 may be disposed on the first via-insulating layer 230 where the second metal conductive layer SD2 is formed, in the main display area MDA. The second via-insulating layer 240 may be formed of an organic insulating material such as an acrylic resin, a polyimide resin, or a polyamide resin. One surface, in the third direction DR3, of the second via-insulating layer 240 may be the top surface of the second via-insulating layer 240 where the third via-insulating layer 250 is disposed, and the other surface, in the third direction DR3, of the second via-insulating layer 240 may be the bottom surface of the second via-insulating layer 240 where the first via-insulating layer 230 is disposed.

The third via-insulating layer 250 may be disposed on the second via-insulating layer 240, in the main display area MDA. The third via-insulating layer 250 may be formed of an organic insulating material such as an acrylic resin, a polyimide resin, or a polyamide resin. One surface, in the third direction DR3, of the third via-insulating layer 250 may be the top surface of the third via-insulating layer 250 where an anode ANO of a first light-emitting element LEL1 is disposed, and the other surface, in the third direction DR3, of the third via-insulating layer 250 may be the bottom surface of the third via-insulating layer 250 where the second via-insulating layer 240 is disposed.

The first light-emitting element LEL1 may include the anode ANO, a first emission layer EML1, and the first cathode CAT1 and may be disposed on the third via-insulating layer 250.

As illustrated in FIG. 12, the anode ANO of the first light-emitting element LEL1 may be electrically connected to the fifth connecting electrode CNE5 through a contact hole that is formed to penetrate the second and third via-insulating layers 240 and 250, and may thus be electrically connected to the fifth drain electrode D5 of the fifth transistor STa5.

The pixel-defining film 260 may be disposed on the third via-insulating layer 250 where the anode ANO is disposed. The pixel-defining film 260 may be formed of an organic material such as an acrylic resin or a polyimide resin. The pixel-defining film 260 may define an opening that exposes part of the anode ANO.

The first emission layer EML1 may be disposed on the anode ANO and the pixel-defining film 260. In a case where the first emission layer EML1 is an organic emission layer including an organic material, the first light-emitting element LEL1 may be an OLED. Alternatively, in a case where the first emission layer EML1 includes a quantum-dot emission layer, the first light-emitting element LEL1 may be a quantum-dot light-emitting element. Alternatively, in a case where the first emission layer EML1 includes an inorganic semiconductor, the first light-emitting element LEL1 may be an inorganic light-emitting element. Alternatively, the first light-emitting element LEL1 may be a microLED.

The first cathode CAT1 may be disposed on the first emission layer EML1. The first cathode CAT1 may cover the entire pixel-defining film 260 where the first emission layer EML1 is formed. In other words, the first cathode CAT1 may have substantially the same thickness along the profile of the pixel-defining film 260 where the first light-emitting element EML1 is formed. The first cathode CAT1 may have substantially the same shape as the main display area MDA in a plan view.

The thin-film encapsulation layer TFE may prevent the penetration of external moisture and oxygen into the first light-emitting element LEL1. The thin-film encapsulation layer TFE may be disposed on the first cathode CAT1 of the first light-emitting element LEL1.

The thin-film encapsulation layer TFE may include at least one organic layer and at least one inorganic layer. The organic layer and the inorganic layer may be alternately stacked. For example, as illustrated in FIG. 12, the thin-film encapsulation layer TFE may include a first encapsulation inorganic layer 440, an encapsulation organic layer 270, which is disposed on the first encapsulation inorganic layer 440, and a second encapsulation inorganic layer 450, which is disposed on the encapsulation organic layer 270.

The first and second encapsulation inorganic layers 440 and 450 may include an inorganic insulating material such as $SiO_xN_y$, and the encapsulation organic layer 270 may include an organic insulating material such as an acrylic resin, a polyimide resin, or a polyamide resin.

The touch sensor layer TSL may be further disposed between the display panel 300 and the cover window 100. The touch sensor layer TSL may sense touch input applied to the display device 1. The touch sensor layer TSL may be disposed on the thin-film encapsulation layer TFE. As illustrated in FIG. 13, the touch sensor layer TSL may include a first touch insulating layer YILD1, a first touch conductive layer YMTL1, a second touch insulating layer YILD2, a second touch conductive layer YMTL2, and a touch protection layer YPVX.

The first touch insulating layer YILD1 may be disposed on the second encapsulation inorganic layer 450 of the thin-film encapsulation layer TFE. The first touch insulating layer YILD1 may include an inorganic insulating material such as $SiO_xN_y$.

The first touch conductive layer YMTL1 may be disposed on the first touch insulating layer YILD1. The first touch conductive layer YMTL1 may include a conductive material.

The second touch insulating layer YILD2 may be disposed on the first touch conductive layer YMTL1. The second touch insulating layer YILD2 may insulate the first and second touch conductive layers YMTL1 and YMTL2. The second touch insulating layer YILD2 may include an inorganic insulating material such as $SiO_xN_y$.

The second touch conductive layer YMTL2 may be disposed on the second touch insulating layer YILD2. The second touch conductive layer YMTL2 may include a conductive material. Although not specifically illustrated, the second touch conductive layer YMTL2 may have a mesh shape in a plan view. The first and second touch conductive layers YMTL1 and YMTL2 may be disposed to overlap with the pixel-defining film 260, but not with the first emission layer EML1 in a plan view, exposed by the pixel-defining film 260.

The touch protection layer YPVX may be disposed on the second touch conductive layer YMTL2. The touch protection layer YPVX may include an organic insulating material such as an acrylic resin, a polyimide resin, or a polyamide resin.

An overcoat layer OCL may be further disposed between the touch sensor layer TSL and the cover window 100. The overcoat layer OCL may reduce the reflection of external light by the display device 1 and may improve the reflection color of the display device 1. The overcoat layer OCL may include a light-blocking pattern BLF, a color filter layer CF, and an overcoat material layer OC.

The light-blocking pattern BLF may reduce the reflection of external light by the display device 1. The light-blocking pattern BLF may be disposed on the touch protection layer YPVX to overlap with the pixel-defining film 260, but not with the first emission layer EML1 of the first light-emitting element LEL1 in a plan view, exposed by the pixel-defining film 260. In other words, the light-blocking pattern BLF may define an opening OA, which overlaps with the first emission layer EML1 of the first light-emitting element LEL1 in a plan view. The light-blocking pattern BLF may include a black pigment.

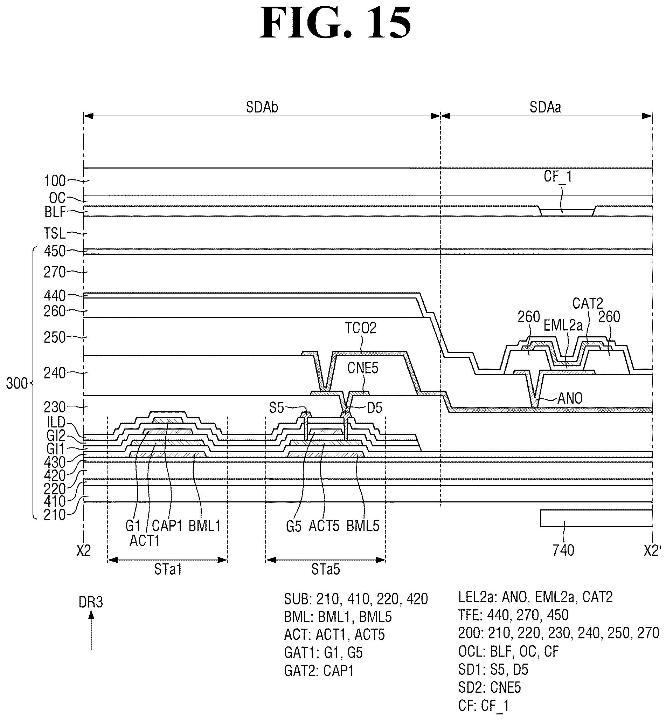

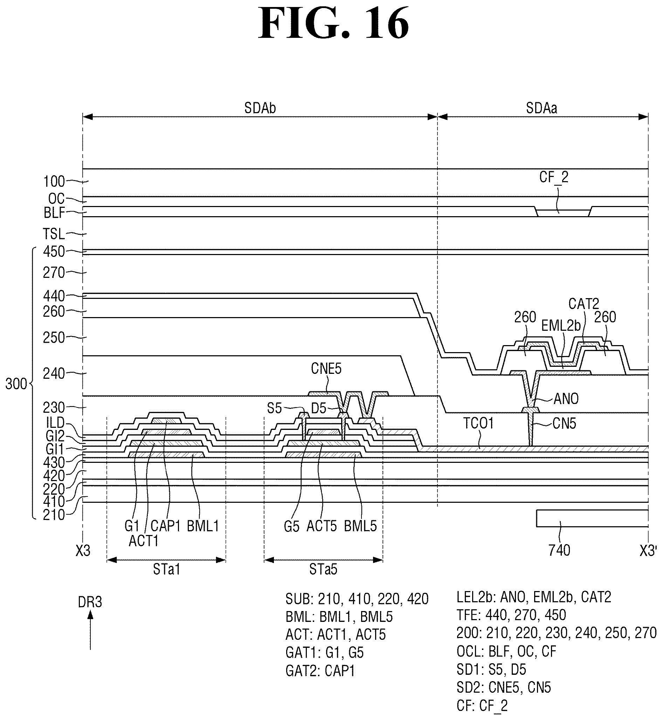

The color filter layer CF may block the emission of light of colors other than the color corresponding to the first emission layer EML1 of the first light-emitting element LEL1. The color filter layer CF may be disposed in the opening OA formed by the light-blocking pattern BLF to overlap with the first emission layer EML1 of the first light-emitting element LEL in a plan view. The color filter layer CF may include a first color filter layer CF_1 (*see* FIG. 15), which emits only blue light, a second color filter layer CF_2 (*see* FIG. 16), which emits only red light, and a third color filter layer (not illustrated), which emits only green light.

The overcoat material layer OC may cover and thereby protect the light-blocking pattern BLF and the color filter layer CF. The overcoat material layer OC may planarize the surfaces of the light-blocking pattern BLF and the color filter layer CF. The overcoat layer OCL may be disposed on the light-blocking pattern BLF and the color filter layer CF. The overcoat layer OCL may include an organic insulating material such as an acrylic resin, a polyimide resin, or a polyamide resin.

At least one of the aforementioned layers may correspond to the optical characteristics-control organic layer 200. The optical characteristics-control organic layer 200, which is a layer whose haze or wavefront characteristic is desirable to be controlled, may be a layer formed of an organic material.

In the main display area MDA, the optical characteristics-control organic layer 200 may include the first and second substrate layers 210 and 220 of the substrate SUB, the first, second, and third via-insulating layers 230, 240, and 250, and the encapsulation organic layer 270 of the thin-film encapsulation layer TFE and may further include the touch protection layer YPVX of the touch sensor layer TSL and the overcoat material layer OC of the overcoat layer OCL.

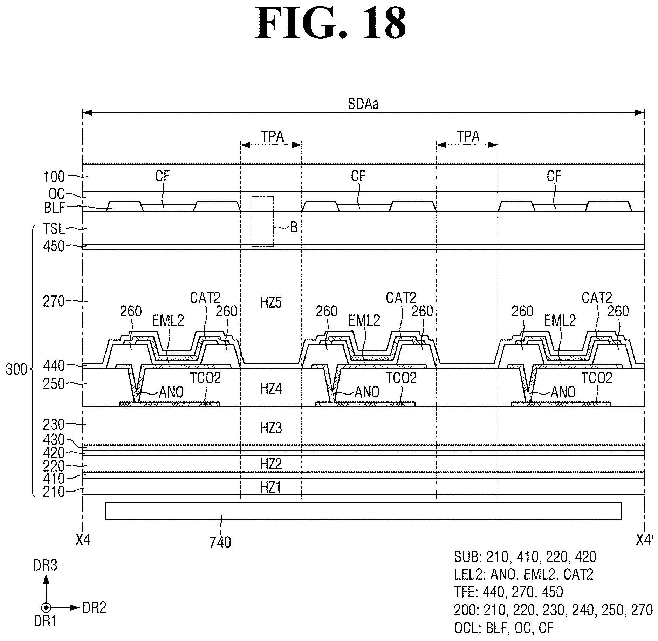

A haze HZ_nt and a wavefront characteristic WF_nt of the main display area MDA of the display panel 300 may reflect the haze and the wavefront characteristic of the optical characteristics-control organic layer 200, i.e., the hazes and the wavefront characteristics of the first and second substrate layers 210 and 220 of the substrate SUB, the first, second, and third via-insulating layers 230, 240, and 250, the encapsulation organic layer 270 of the thin-film encapsulation layer TFE, the touch protection layer YPVX of the touch sensor layer TSL, and the overcoat material layer OC of the overcoat layer OCL, and this will be described later with reference to FIGS. 18 through 21.

The optical characteristics-control organic layer 200 may include one of an acrylic resin, a polyimide resin, or a polyamide resin as an ultraviolet ("UV") curing resin. The haze and the wavefront characteristic of the optical characteristics-control organic layer 200 may be controlled by controlling a set of conditions for forming the optical characteristics-control organic layer 200, and this will be described later.

The structure of the display panel 300 in the sub-display area SDA will hereinafter be described.

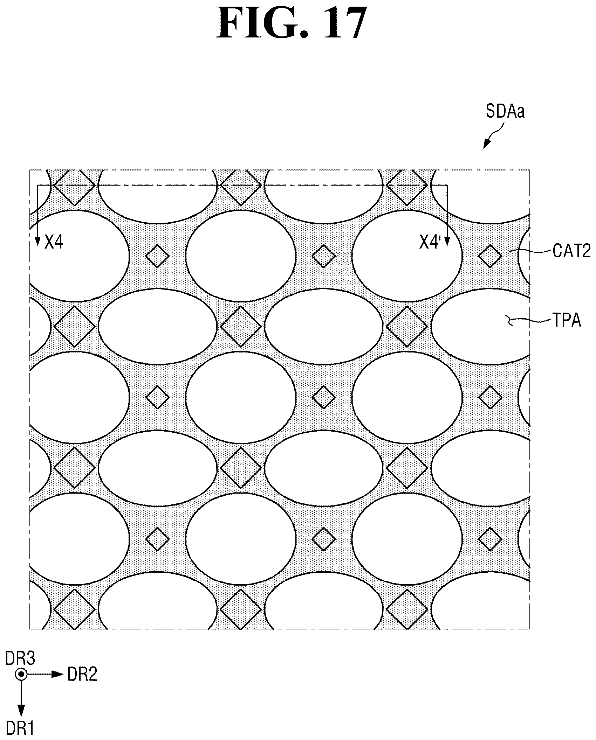

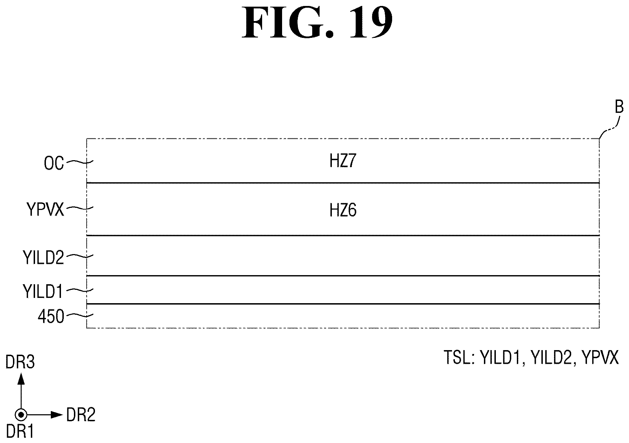

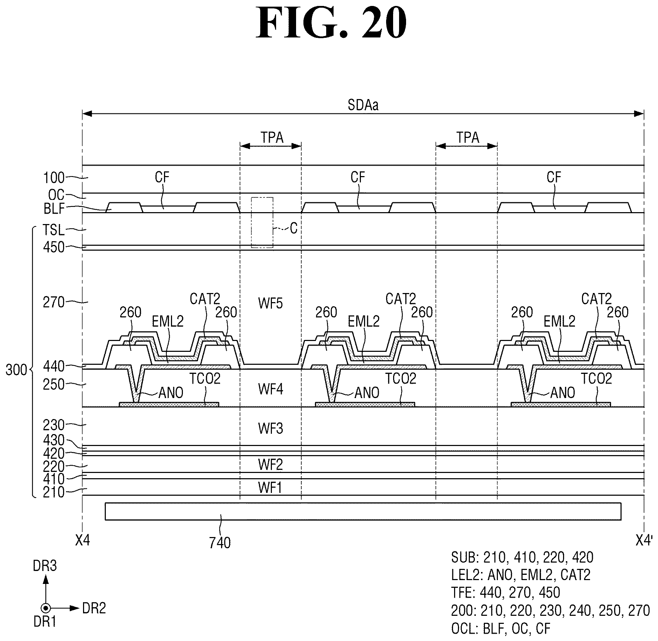

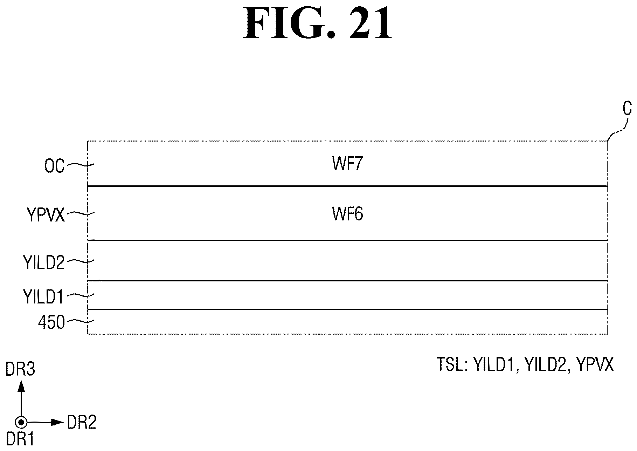

FIG. 14 is a plan view illustrating the layout of first subpixels and second subpixels in the sub-display area of the display panel of FIG. 8. FIG. 15 is a cross-sectional view taken along line X2-X2' of FIG. 14. FIG. 16 is a cross-sectional view taken along line X3-X3' of FIG. 14. FIG. 17 is a plan view illustrating the layout of a second cathode on second subpixels in the first sub-display area of the display panel of FIG. 8. FIG. 18 is a cross-sectional view, taken along line X4-X4' of FIG. 17, for explaining the haze of each layer of the display panel of FIG. 8. FIG. 19 is an enlarged cross-sectional view of an area B of FIG. 18. FIG. 20 is a cross-sectional view, taken along line X4-X4' of FIG. 17, for explaining the haze of each layer of the display panel of FIG. 8 according to another embodiment. FIG. 21 is an enlarged cross-sectional view of an area C of FIG. 20.

Referring to FIGS. 14 and 17, second subpixels PXL2 may be disposed in the sub-display area SDA. Specifically, each of the second subpixels PXL2 may include a second light-emitting element LEL2 and a second TFT TR2. The second light-emitting element LEL2 may be disposed only in the first sub-display area SDAa, the second TFT TR2 may be disposed only in the second sub-display area SDAb, and the second TFT TR2 and the second light-emitting element LEL2 may be electrically connected by a transparent oxide conductive layer. In other words, the second light-emitting element LEL2 may overlap with the first sub-display area SDAa, but not with the second sub-display area SDAb and the main display area MDA in a plan view, and the second TFT TR2 may overlap with the second sub-display area SDAb, but not with the first sub-display area SDAa and the main display area MDA in a plan view. In other words, the second TFT TR2 may not overlap with the first sub-display area SDAa in the third direction DR3.

The second sub-pixels PXL2 are classified into (2_1)-th subpixels PXL2a, (2_2)-th subpixels PXL2b, (2_3)-th subpixels PXL2c, and (2_4)-th subpixels PXL2d depending on their locations. (2_1)-th, (2_2)-th, (2_3)-th, and (2_4)-th subpixels PXL2a, PXL2b, PXL2c, and PXL2d may gather together to form a pixel capable of displaying white light. A second subpixel PXL2 on a second side, in the first direction DR1, and a second side, in the second direction DR2, of the center of the pixel (i.e., upper left part of the pixel) may be the (2-1)-th subpixel PXL2a. A second subpixel PXL2 on a first side, in the first direction DR1, and the second side, in the second direction DR2, of the center of the pixel (i.e., lower left part of the pixel) may be the (2_2)-th subpixel PXL2b. A second subpixel PXL2 on the second side, in the first direction DR1, and the first side, in the second direction DR2, of the center of the pixel (i.e., upper right part of the pixel) may be the (2_3)-th subpixel PXL2c. A second subpixel PXL2 on the first side, in the first direction DR1, and the first side, in the second direction DR2, of the center of the pixel (i.e., lower right part of the pixel) may be the (2_4)-th subpixel PXL2d. Accordingly, second TFTs TR2 may be classified into (2_1)-th, (2_2)-th, (2_3)-th, and (2_4)-th TFTs TR2a, TR2b, TR2c, and TR2d, and second light-emitting elements LEL2 may be classified into (2_1)-th, (2_2)-th, (2_3)-th, and (2_4)-th light-emitting elements LEL2a, LEL2b, LEL2c, and LEL2d.

The (2_1)-th subpixel PXL2a may include the (2_1)-th TFT TR2a and the (2_1)-th light-emitting element LEL2a, the (2_2)-th subpixel PXL2b may include the (2_2)-th TFT TR1b and the (2_2)-th light-emitting element LEL2b, the (2_3)-th subpixel PXL2c may include the (2_3)-th TFT TR1c and the (2_3)-th light-emitting element LEL2c, and the (2_4)-th subpixel PXL2d may include the (2_4)-th TFT TR1d and the (2_4)-th light-emitting element LEL2d.

The (2_1)-th light-emitting element LEL2a and the (2_1)-th TFT TR2a may be electrically connected by a second transparent conductive layer TCO2, the (2_2)-th light-emitting element LEL2b and the (2_2)-th TFT TR2b may be electrically connected by a first transparent conductive layer TCO1, the (2_3)-th light-emitting element LEL2c and the (2_3)-th TFT TR2c may be electrically connected by a first transparent conductive layer TCO1, and the (2_4)-th light-emitting element LEL2d and the (2_4)-th TFT TR2d may be electrically connected by a first transparent conductive layer TCO1.

The (2_1)-th, (2_2)-th, (2_3)-th, and (2_4)-th subpixels PXL2a, PXL2b, PXL2c, and PXL2d may emit light of different colors, but the disclosure is not limited thereto. Alternatively, the (2_1)-th subpixel PXL2a may display blue light, the (2_2)-th subpixel PXL2b may display red light, and the (2_3)-th and (2_4)-th subpixels PXL2c and PXL2d may display green light in another embodiment. The second light-emitting elements LEL2 may have a rhombus shape in a plan view, but the disclosure is not limited thereto. Alternatively, the second light-emitting elements LEL2 may have a circular or rectangular shape in a plan view. The (2_1)-th and (2_2)-th light-emitting elements LEL2a and LEL2b may each have a larger size than each of the (2_3)-th and (2_4)-th light-emitting elements LEL2c and LEL2d in another embodiment, but the disclosure is not limited thereto.

The first sub-display area SDAa may include the second light-emitting elements LEL2 of the second subpixels PXL2 and light-transmitting parts TPA, which are disposed in the gaps between the second light-emitting elements LEL2. A second cathode CAT2 may have a mesh shape in a plan view (See FIG. 17). Specifically, a second cathode CAT2 where openings that expose the light-transmitting parts TPA in the third direction DR3 may be disposed in the first sub-display area SDAa. Accordingly, the light transmittance of the light-transmitting parts TPA can be maximized.

As the second subpixels PXL2 are spaced apart from one another to form the light-transmitting parts TPA in the first sub-display area SDAa, the pixel density of the first sub-display area SDAa may be less than the pixel density of the main display area MDA.

In the second sub-display area SDAb, second TFTs TR2 of second subpixels PXL2 and first subpixels PXL1 may be disposed. First subpixels PXL1 may also be disposed in the second sub-display area SDAb and may include first TFTs TR1 and first light-emitting elements LEL1, which are disposed on, and electrically connected to, the first TFTs TR1, and the first light-emitting elements LEL1 may overlap with the first TFTs TR1 in the third direction DR3.

In the second sub-display area SDAb, unlike in the main display area MDA, there may be gaps between the first subpixels PXL1, and the second TFTs TR2 of the second subpixels PXL2 may be disposed in the gaps between the first subpixels PXL1. In other words, the second TFTs TR2 of the second subpixels PXL2 may be disposed between the first subpixels PXL1. In this case, the first light-emitting elements LEL1 of the first subpixels PXL1 may be disposed in the second sub-display area SDAb, and the density of first light-emitting elements LEL1 in the second sub-display area SDAb may be less than the density of first light-emitting elements LEL1 in the main display area MDA. Accordingly, the pixel density of the second sub-display area SDAb may be less than the pixel density of the main display area MDA.

Referring to FIGS. 15 and 16, a second subpixel PXL2 may include a second light-emitting element LEL2, which is disposed in the first sub-display area SDAa, and a second TFT TR2, which is disposed in the second sub-display area SDAb, and the second light-emitting element LEL2 and the second TFT TR2 may not overlap with each other in the third direction DR3. The second TFT TR2 and the second light-emitting element LEL2 may be electrically connected by a first transparent conductive layer TCO1 or a second transparent conductive layer TCO2. Part of the second sub-display area SDAb including first subpixels PXL1 may have the same structure as the main display area MDA of the display panel 300, and thus, a detailed description thereof will be omitted.

Referring to FIG. 15, a second TFT TR2 and a second light-emitting element LEL2 of a second subpixel PXL2 may be electrically connected by a second transparent conductive layer TCO2. Specifically, the second sub-display area SDAb may have substantially the same structure as the main display area MDA, except that part of the sub-display area SDAb where the second TFT TR2 of the second subpixel PXL2 is disposed has a structure where the substrate SUB, the lower metal layer BML, the buffer layer 430, the semiconductor layer ACT, the first gate insulating layer GI1, the first gate conductive layer GAT1, the second gate insulating layer GI2, the second gate conductive layer GAT2, the interlayer insulating layer ILD, the first metal conductive layer SD1, the first via-insulating layer 230, the second metal conductive layer SD2, the second via-insulating layer 240, the second transparent conductive layer TCO2, the third via-insulating layer 250, the pixel-defining film 260, and the thin-film encapsulation layer TFE are sequentially stacked. In this case, the second light-emitting element LEL2 may be a (2_1)-th light-emitting element LEL2a, which is disposed in the first sub-display area SDAa. In a case where the (2_1)-th light-emitting element LEL2a emits blue light, the color filter layer CF of the overcoat layer OCL may correspond to the first color filter CF_1, which emits only blue light. For convenience, FIG. 15 illustrates only first and fifth transistors STb1 and STb5 of the second TFT TR2.

The second TFT TR2 may have substantially the same structure as a first TFT TR1, and thus, a detailed description thereof will be omitted. In other words, the structure of the second sub-display area SDAb that ranges across the substrate SUB, the lower metal layer BML, the buffer layer 430, the semiconductor layer ACT, the first gate insulating layer GI1, the first gate conductive layer GAT1, the second gate insulating layer GI2, the second gate conductive layer GAT2, the interlayer insulating layer ILD, the first metal conductive layer SD1, the first via-insulating layer 230, the second metal conductive layer SD23, and the second via layer 240 to the second via-insulating layer 240 may be substantially the same as the structure of the main display area MDA, and thus, a detailed description thereof will be omitted.

Part of the second sub-display area SDAb where the second TFT TR2 of the second subpixel PXL2 is disposed may further include the second transparent conductive layer TCO2, which is formed on the second via-insulating layer 240.

The second transparent conductive layer TCO2 may electrically connect the second TFT TR2 and the second light-emitting element LEL2. The second transparent conductive layer TCO2 may be electrically connected to a fifth connecting electrode CNE5 through a contact hole that penetrates the second via-insulating layer 240. The second transparent conductive layer TCO2 may include a material that has electrical conductivity and transmits visible light therethrough. For example, the second transparent conductive layer TCO2 may include indium tin oxide ("ITO").

As a first light-emitting element LEL1 and the second light-emitting element LEL2 of the second subpixel PXL2 are not disposed in the part of the second sub-display area SDAb where the second TFT TR2 of the second subpixel PXL2 is disposed, the third via-insulating layer 250 may be disposed on the second transparent conductive layer TCO2, and the thin-film encapsulation layer TFE may be disposed on the pixel-defining film 260.

Referring to FIG. 16, a second TFT TR2 and a second light-emitting element LEL2 of a second subpixel PXL2 may be electrically connected by a first transparent conductive layer TCO1. Specifically, the second sub-display area SDAb may have substantially the same structure as the main display area MDA, except that part of the sub-display area SDAb where the second TFT TR2 of the second subpixel PXL2 is disposed has a structure where the substrate SUB, the lower metal layer BML, the buffer layer 430, the semiconductor layer ACT, the first gate insulating layer GI1, the first gate conductive layer GAT1, the second gate insulating layer GI2, the second gate conductive layer GAT2, the interlayer insulating layer ILD, the first metal conductive layer SD1, the first transparent conductive layer TCO1, the first via-insulating layer 230, the second metal conductive layer SD2, the second via-insulating layer 240, the third via-insulating layer 250, the pixel-defining film 260, and the thin-film encapsulation layer TFE are sequentially stacked. In this case, the second light-emitting element LEL2, which is disposed in the first sub-display area SDAa, may be one of (2_2)-th, (2_3)-th, and (2_4)-th light-emitting elements LEL2b, LEL2c, and LEL2d. For example, in a case where the (2_2)-th light-emitting element LEL2b emits red light, the color filter layer CF of the overcoat layer OCL may correspond to the second color filter CF_2, which emits only red light. For convenience, FIG. 16 illustrates only first and fifth transistors STb1 and STb5 of the second TFT TR2.

The second TFT TR2 may have substantially the same structure as a first TFT TR1, and thus, a detailed description thereof will be omitted. In other words, the structure of the second sub-display area SDAb that ranges across the substrate SUB, the lower metal layer BML, the buffer layer 430, the semiconductor layer ACT, the first gate insulating layer GI1, the first gate conductive layer GAT1, the second gate insulating layer GI2, the second gate conductive layer GAT2, the interlayer insulating layer ILD, and the first metal conductive layer SD1 may be substantially the same as the structure of the main display area MDA, and thus, a detailed description thereof will be omitted.

The first metal conductive layer SD1 and the first transparent conductive layer TCO1 may be disposed on the interlayer insulating layer ILD. The first metal conductive layer SD1 has already been described, and thus, a detailed description thereof will be omitted.

The first transparent conductive layer TCO1 may electrically connect the second TFT TR2 and the second light-emitting element LEL2. The first transparent conductive layer TCO1 may be electrically connected to a fifth connecting electrode CNE5 through a contact hole that penetrates the first via-insulating layer 230. Accordingly, the first transparent conductive layer TCO1 may be electrically connected to a fifth drain electrode D5 by the fifth connecting electrode CNE5. The first transparent conductive layer TCO1 may include a material that has electrical conductivity and transmits visible light therethrough. For example, the first transparent conductive layer TCO1 may include ITO.

The second via-insulating layer 240 is substantially the same as its counterpart of FIG. 15 except that a second transparent conductive layer TCO2 is not provided, and thus, a detailed description thereof will be omitted.

The first gate insulating layer GI1, the second gate insulating layer GI2, the interlayer insulating layer ILD, and the second via-insulating layer 240 may be disconnected near the boundary between the first sub-display area SDAa and the second sub-display area SDAb to form a height difference in the first sub-display area SDAa. In other words, the first gate insulating layer GI1, the second gate insulating layer GI2, the interlayer insulating layer ILD, and the second via-insulating layer 240 may be removed from near the boundary between the first sub-display area SDAa and the second sub-display area SDAb and may thus not be disposed in the first sub-display area SDAa.

The height difference formed in the first sub-display area SDAa may be compensated for by the encapsulation organic layer 270 of the thin-film encapsulation layer TFE. In other words, the width, in the third direction DR3, of the encapsulation organic layer 270 (or the thickness of the encapsulation organic layer 270) may be greater in the first sub-display area SDAa than in the main display area MDA and the second sub-display area SDAb.

Accordingly, as illustrated in FIG. 15, the second transparent conductive layer TCO2 may extend along a side of the second via-insulating layer 240 near the boundary between the first sub-display area SDAa and the second sub-display area SDAb and may thus be disposed on a surface, in the third direction DR3, of the first via-insulating layer 230, in the first sub-display area SDAa. In this case, the anode ANO of the second light-emitting element LEL2 may be electrically connected to the second transparent conductive layer TCO2 through a contact hole that penetrates the third via-insulating layer 250.

Also, as illustrated in FIG. 16, the first transparent conductive layer TCO1 may extend along sides of the interlayer insulating layer ILD, the second gate insulating layer GI2, and the first gate insulating layer GI1 near the boundary between the first sub-display areas SDAa and the second sub-display area SDAb and may thus be disposed on a surface, in the third direction DR3, of the via layer 430, in the first sub-display area SDAa. In this case, a fifth connecting node CN5 may be formed on the first via-insulating layer 230, in the first sub-display area SDAa. In other words, the second metal conductive layer SD2 may include the fifth connecting electrode CNE5 and the fifth connecting node CN5. The fifth connecting node CN5 may be electrically connected to the first transparent conductive layer TCO1 through a contact hole that penetrates the first via-insulating layer 230, and an anode ANO of the second light-emitting element LEL2 may be electrically connected to the fifth connecting node CN5 through a contact hole that penetrates the third via-insulating layer 250 and may thus be electrically connected to the first transparent conductive layer TCO1.

Referring to FIGS. 18 through 22, the display panel 300 may not include, in the first sub-display area SDAa, the semiconductor layer ACT1, the first gate insulating layer GI1, the first gate conductive layer GAT1, the second gate insulating layer GI2, the second gate conductive layer GAT2, the interlayer insulating layer ILD, the first metal conductive layer SD1, the second metal conductive layer SD2, and the second via-insulating layer 240. That is, the display panel 300 may include, in the first sub-display area SDAa, the substrate SUB, the buffer layer 430 on the substrate SUB, the first via-insulating layer 230 on the buffer layer 430, the second transparent conductive layer TCO2 on the first via-insulating layer 230, the third via-insulating layer 250 on the second transparent conductive layer TCO2, a pixel-defining film 260 on the third via-insulating layer 250, second light-emitting elements LEL2 on the pixel-defining film 260, and the thin-film encapsulation layer TFE on the second light-emitting elements LEL2. For convenience, the second light-emitting elements LEL2 and second TFTs TR2 will hereinafter be described as being electrically connected by the second transparent conductive layer TCO2.

The pixel-defining film 260, which is formed on the third via-insulating layer 250, may not be formed in areas that overlap with the light-transmitting parts TPA of the first sub-display area SDAa in a plan view. In other words, parts of the pixel-defining film 260 may be spaced apart from one another by the light-transmitting parts TPA.

Each of the second light-emitting elements LEL2, which are disposed in the first sub-display area SDAa, may include an anode ANO, a second emission layer EML2, and a second cathode CAT2. As the second cathode CAT2 is patterned to expose the light-transmitting parts TPA, the second cathode CAT2 may not be formed in the areas that overlap with the light-transmitting parts TPA in a plan view. In other words, the second cathode CAT2 may cover parts of the pixel-defining film 260. That is, parts of the second cathode CAT2 may be spaced apart from one another by the light-transmitting parts TPA. Accordingly, the second light-emitting elements LEL2 may be spaced apart from one another by the light-transmitting parts TPA.

In a case where the touch sensor layer TSL and the overcoat layer OCL are further provided above the display panel 300, the first and second touch conductive layers YMTL1 and YMTL2 of the touch sensor layer TSL and light-blocking patterns BLF and color filters of the overcoat layer OCL may not be disposed in the areas that overlap with the light-transmitting parts TPA in a plan view, as illustrated in FIGS. 19 and 21. Accordingly, the light transmittance of the light-transmitting parts TPA can be maximized.

At least one of the aforementioned layers may correspond to the optical characteristics-control organic layer 200. The optical characteristics-control organic layer 200, which is a layer whose haze or wavefront characteristic is desirable to be controlled, may be a layer formed of an organic material.

In the light-transmitting parts TPA of the first sub-display area SDAa, the optical characteristics-control organic layer 200 may include the first and second substrate layers 210 and 220 of the substrate SUB, the first via-insulating layer 230, the third via-insulating layer 250, and the encapsulation organic layer 270 of the thin-film encapsulation layer TFE and may further include the touch protection layer YPVX of the touch sensor layer TSL and the overcoat material layer OC of the overcoat layer OCL.

A haze HZ_t and a wavefront characteristic WF_t of the display panel 300 in the light-transmitting parts TPA of the first sub-display area SDAa may reflect the haze and the wavefront characteristic of the optical characteristics-control organic layer 200, i.e., the hazes and the wavefront characteristics of the first and second substrate layers 210 and 220 of the substrate SUB, the first and third via-insulating layers 230 and 250, the encapsulation organic layer 270 of the thin-film encapsulation layer TFE, the touch protection layer YPVX of the touch sensor layer TSL, and the overcoat material layer OC of the overcoat layer OCL.

For example, the haze HZ_t of the display panel 300 in the light-transmitting parts TPA of the first sub-display area SDAa may be defined as reflecting a haze HZ1 of the first substrate layer 210, a haze HZ2 of the second substrate layer 220, a haze HZ3 of the first via-insulating layer 230, a haze HZ4 of the third via-insulating layer 250, and a haze HZ5 of the encapsulation organic layer 270. In a case where the touch protection layer YPVX and the overcoat layer OCL are further provided, the haze HZ_t of the display panel 300 in the light-transmitting parts TPA of the first sub-display area SDAa may further reflect a haze HZ6 of the touch protection layer YPVX and a haze HZ7 of the overcoat material layer OC.

For example, the wavefront characteristic WF_t of the display panel 300 in the light-transmitting parts TPA of the first sub-display area SDAa may be defined as reflecting a wavefront characteristic WF1 of the first substrate layer 210, a wavefront characteristic WF2 of the second substrate layer 220, a wavefront characteristic WF3 of the first via-insulating layer 230, a wavefront characteristic WF4 of the third via-insulating layer 250, and a wavefront characteristic WF5 of the encapsulation organic layer 270. In a case where the touch protection layer YPVX and the overcoat layer OCL are further provided, the wavefront characteristic WF_t of the display panel 300 in the light-transmitting parts TPA of the first sub-display area SDAa may further reflect a wavefront characteristic WF6 of the touch protection layer YPVX and a wavefront characteristic WF7 of the overcoat material layer OC.

The haze HZ_t and the wavefront characteristic WF_t of the display panel 300 in the light-transmitting parts TPA of the first sub-display area SDAa may be less than the haze HZ_nt and the wavefront characteristic WF_nt of the display panel 300 in the main display area MDA in their values.

Specifically, as in the main display area MDA, unlike in the light-transmitting parts TPA of the first sub-display area SDAa, the display panel 300 further includes the second via-insulating layer 240 as the optical characteristics-control organic layer 200, as illustrated in FIG. 12, a haze HZ_a and a wavefront characteristic WF_a of the second via-insulating layer 240 is desirable to be additionally considered when considering the haze HZ_nt and the wavefront characteristic WF_nt of the display panel 300 in the main display area MDA. Thus, the values of the haze HZ_nt and the wavefront characteristic WF_nt of the display panel 300 in the main display area MDA may be greater than the values of the haze HZ_t and the wavefront characteristic WF_t of the display panel 300 in the light-transmitting parts TPA of the first sub-display area SDAa. In other words, the haze HZ_t of the display panel 300 in the light-transmitting parts TPA of the first sub-display area SDAa may be less than the haze HZ_nt of the display panel 300 in the main display area MDA in their values.

The optical characteristics-control organic layer 200 may include at least one UV curing resin such as an acrylic resin, a polyimide resin, and a polyamide resin. Accordingly, the haze and the wavefront characteristic of the optical characteristics-control organic layer 200 can be controlled by controlling a set of conditions for forming the optical characteristics-control organic layer 200.

Specifically, the haze of the optical characteristics-control organic layer 200 may considerably vary depending on the duration of leveling for planarizing the optical characteristics-control organic layer 200 before the curing of the optical characteristics-control organic layer 200. For example, the shorter the duration of leveling is, the higher the haze of the optical characteristics-control organic layer 200 may become because of the optical characteristics-control organic layer 200 not being able to be properly planarized, and the longer the duration of leveling is, the lower the haze of the optical characteristics-control organic layer 200 may become because of the optical characteristics-control organic layer 200 being able to be properly planarized.

The wavefront characteristic of the optical characteristics-control organic layer 200 may considerably vary depending on a set of conditions for curing the optical characteristics-control organic layer 200. For example, if the optical characteristics-control organic layer 200 is cured at high temperature or only for a short period of time, the internal uniformity of the optical characteristics-control organic layer 200 may decrease so that the P-V wavefront value and the RMS wavefront value of the optical characteristics-control organic layer 200 may increase, and if the optical characteristics-control organic layer 200 is cured at low temperature or for a long period of time, the internal uniformity of the optical characteristics-control organic layer 200 may increase so that the P-V wavefront value and the RMS wavefront value of the optical characteristics-control organic layer 200 may decrease.

The wavefront characteristic of the optical characteristics-control organic layer 200 may be adjusted by controlling the conditions for curing the optical characteristics-control organic layer 200 to differ from the main display area MDA to the light-transmitting parts TPA of the first sub-display area SDAa. Specifically, the value of the wavefront characteristic WF_nt of the display panel 300 in the main display area MDA may be greater than the value of the wavefront characteristic WF_t of the display panel 300 in the light-transmitting parts TPA of the first sub-display area SDAa by raising the temperature and the speed at which to cure the optical characteristics-control organic layer 200 in the main display area MDA and lowering the temperature and the speed at which to cure the optical characteristics-control organic layer 200 in the light-transmitting parts TPA of the first sub-display area SDAa. In other words, the value of the wavefront characteristic WF_t of the display panel 300 in the light-transmitting parts TPA of the first sub-display area SDAa may be less than the value of the wavefront characteristic WF_nt of the display panel 300 in the main display area MDA.

As the inorganic insulating layers of the display panel 300, i.e., the first and second barrier layers 410 and 420, the buffer layer 430, the first encapsulation inorganic layer 440, the first and second gate insulating layers GI1 and GI2, and the interlayer insulating layer ILD, have a low haze and a low wavefront characteristic, the inorganic insulating layers of the display panel 300 may not be considered when controlling the haze HZ_t and the wavefront characteristic WF_t of the display panel 300 in the light-transmitting parts TPA of the first sub-display area SDAa.

Accordingly, in the display device 1, the values of the haze HZ_t and the wavefront characteristic WF_t of the display panel 300 in the light-transmitting parts TPA of the first sub-display area SDAa may be less than the values of the haze HZ_nt and the wavefront characteristic WF_nt of the display panel 300 in the main display area MDA, respectively.

The MTF of the optical devices of the display device 1 may be affected by the haze HZ_t and the wavefront characteristic WF_t of the display panel 300 in the light-transmitting parts TPA of the first sub-display area SDAa. The inventors of the disclosure calculated the haze and the wavefront characteristic that can achieve an MTF of 50% at 110 lp/mm, as indicated by Table 1 below.

[Table 1]

| Haze (%) | 4 or Less |
|---|---|
| P-V Wavefront Value ($\mu$m) | 2 or Less |
| RMS Wavefront Value | 0.4 or Less |

According to Table 1, the display panel 300 in the light-transmitting parts TPA of the first sub-display area SDAa may have a haze HZ_t of 4%, a P-V wavefront value of about 2 micrometers ($\mu$m) or less, and an RMS wavefront value of 0.4 or less to achieve an MTF of 50% at 110 lp/mm.

In this manner, the MTF of the optical devices of the display device 1 can be improved.

A structure capable of improving the light transmittance of the display panel 300 by controlling the refractive index of each layer of the display panel 300 will hereinafter be described.

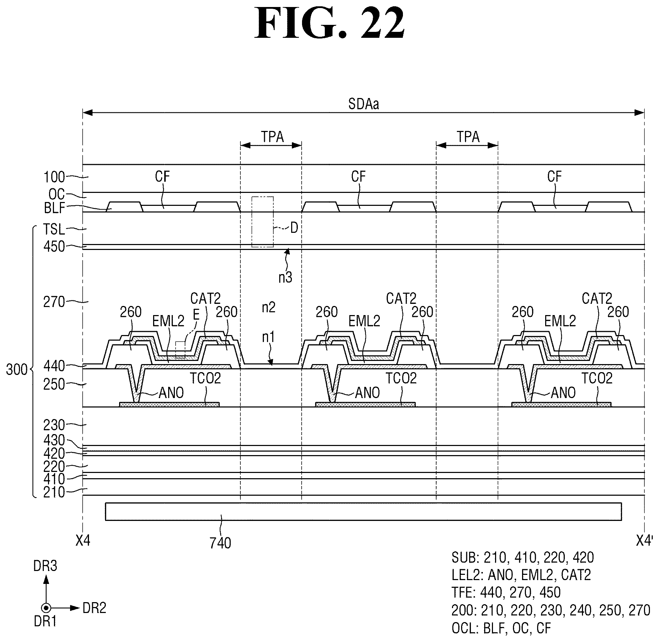

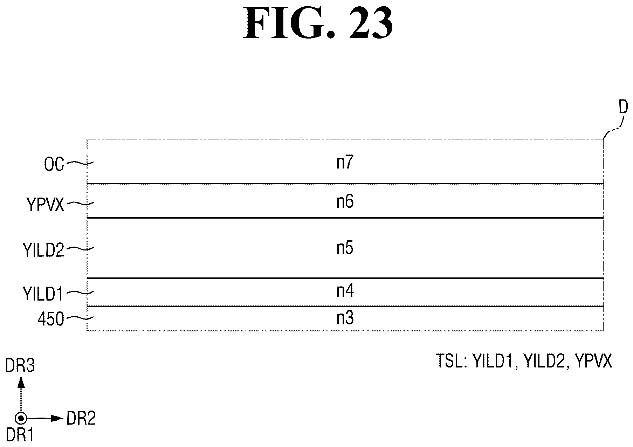

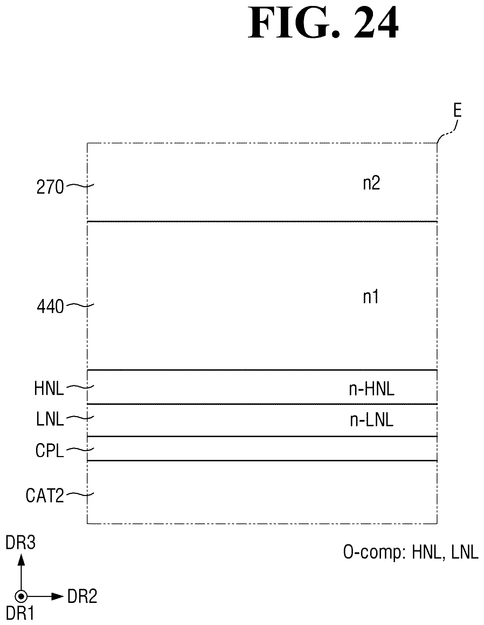

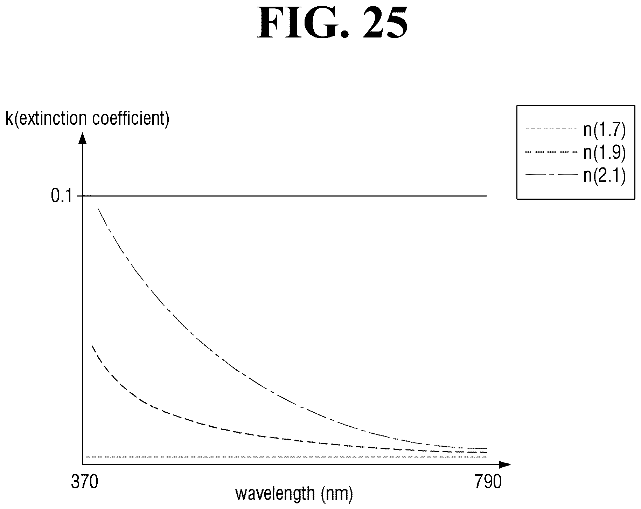

FIG. 22 is a cross-sectional view, taken along line X4-X4' of FIG. 17, for explaining the refractive index of each layer of the display panel of FIG. 8 according to still another embodiment. FIG. 23 is an enlarged cross-sectional view of an area D of FIG. 22. FIG. 24 is an enlarged cross-sectional view of an area E of FIG. 22. FIG. 25 is a graph showing the variation of an extinction coefficient against a refractive index.

The greater the intensity of light arriving at the optical devices of the display device 1 is, the better the performance of the optical devices of the display device 1 becomes. Accordingly, it is desirable to improve the light transmittance of the light-transmitting parts TPA of the first sub-display area SDAa, which transmit therethrough light incident thereupon from the front surface of the display device 1.

Referring to FIGS. 22 through 24, the display panel 300 of the display device 1 may be configured such that a refractive index n1 of the first encapsulation inorganic layer 440, a refractive index n2 of the encapsulation organic layer 270, and a refractive index n3 of the second encapsulation inorganic layer 450 may each be about 1.5 to about 1.7. In a case where the touch sensor layer TSL or the overcoat layer OCL is further provided, the display panel 300 of the display device 1 may be further configured such that a refractive index n4 of the first touch insulating layer YILD1 of the touch sensor layer TSL, a refractive index n5 of the second touch insulating layer YILD2 of the touch sensor layer TSL, and a refractive index n6 of the touch protection layer YPVX of the touch sensor layer TSL or a refractive index n7 of the overcoat material layer OC of the overcoat layer OCL may also be about 1.5 to about 1.7. In other words, the refractive indexes of the first encapsulation inorganic layer 440 and the organic or inorganic layers on the first encapsulation inorganic layer 440, i.e., the refractive indexes n1 through n7, may all be set to about 1.5 to about 1.7.

Specifically, as illustrated in FIG. 24, a capping layer CPL, an optical compensation layer O-comp, the first encapsulation inorganic layer 440, and the encapsulation organic layer 270 may be sequentially stacked on the second cathode CAT2. In other words, the capping layer CPL and the optical compensation layer O-comp may be disposed between the thin-film encapsulation layer TFE and the second cathode CAT2.

The capping layer CPL may protect the second cathode CAT2. The capping layer CPL may be disposed on the second cathode CAT2. The capping layer CPL may have substantially the same thickness along the profile of the cathode CAT2. The capping layer CPL may include an organic insulating material.

The optical compensation layer O-comp may improve a resonance effect by reflecting light reflected from light-emitting elements. The optical compensation layer O-comp may be disposed on the capping layer CPL. The optical compensation layer O-comp may include a low refractive index layer LNL and a high refractive index layer HNL.

A refractive index n-LNL of the low refractive index layer LNL may be about 1.5 or less, and a refractive index n-HNL of the high refractive index layer HNL may be about 1.8 or greater. The high refractive index layer HNL may be disposed on the low refractive index layer LNL. Accordingly, light emitted from light-emitting elements may travel toward one side in the third direction DR3 to pass through the low refractive index layer LNL and then the high refractive index layer HNL. In this case, as the emitted light travels from a layer with a low refractive layer to a layer with a high refractive index, the emitted light may be reflected at the boundary between the low refractive index layer LNL and the high refractive index layer HNL to travel back toward the light-emitting elements, i.e., toward the other side in the third direction DR3, and may then be reflected again by anodes ANO of the light-emitting elements to cause a resonance effect together with light newly emitted from the light-emitting elements.

As the refractive index n-LNL of the low refractive index layer LNL is desirable to be maintained at about 1.5 or less and the refractive index n-HNL of the high refractive index layer HNL is desirable to be maintained at about 1.8 or greater, the light transmittance of the light-transmitting parts TPA can be improved by controlling the refractive indexes of the organic or inorganic layers on the optical compensation layer O-comp, i.e., the refractive indexes n1 through n7.

The refractive index of a material is correlated with the extinction coefficient of the material, which is a measure of the absorption of incident light. A large extinction coefficient means a high light transmittance due to a large amount of light being absorbed, and a small extinction coefficient means a low light transmittance due to a small amount of light being absorbed. Generally, the higher the refractive index, the greater the extinction coefficient, and the lower the refractive index, the less the extinction coefficient. Referring to FIG. 25, when the refractive index is about 1.7 or less, the extinction coefficient may substantially converge on zero. Thus, the refractive indexes of the first encapsulation inorganic layer 440 and the organic or inorganic layers on the first encapsulation inorganic layer 440, i.e., the refractive indexes n1 through n7, may be set to about 1.7 or less.

If the refractive indexes n1 through n7 are about 1.5 or less, foreign materials are highly likely to penetrate each layer of the display panel 300, and as a result, the first encapsulation inorganic layer 440 and the organic or inorganic layers on the first encapsulation inorganic layer 440 may not be able to properly serve as insulating layers, and it is difficult to fabricate inorganic layers having a refractive index of about 1.5 or less. Thus, the refractive indexes of the first encapsulation inorganic layer 440 and the organic or inorganic layers on the first encapsulation inorganic layer 440, i.e., the refractive indexes n1 through n7, may be set to about 1.5 or greater.

The refractive layer of a layer formed of an inorganic insulating material such as $SiO_xN_y$ may be controlled by the content of oxygen (O) in the layer. Specifically, as the content of O in a $SiO_xN_y$ layer increases, the refractive index of the $SiO_xN_y$ layer may decrease, and as the content of O in the $SiO_xN_y$ layer decreases, the refractive index of the $SiO_xN_y$ layer may increase. For example, the refractive index of silicon oxide ($SiO_x$) may range from about 1.4 to about 1.5, and the refractive index of silicon nitride ($SiN_x$) may range from about 1.89 to about 1.9. Thus, the refractive indexes n1 and n3 of the first and second encapsulation inorganic layers 440 and 450 may be set to about 1.5 to about 1.7 by controlling the oxygen contents of the first and second encapsulation inorganic layers 440 and 450. In a case where the touch sensor layer TSL and the overcoat layer OCL are further provided, the refractive indexes n4 and n5 of the first and second touch insulating layers YILD1 and YILD2 may be set to be about 1.5 to about 1.7 by controlling the oxygen contents of the first and second touch insulating layers YILD1 and YILD2.

The refractive index of a layer formed of an organic insulating material is about 1.5. The refractive index of a layer formed of an organic insulating material may be controlled by adding a high refractive index material to the layer. Thus, the refractive index of the encapsulation organic layer 270 may be set to about 1.5 to about 1.7 by adding a high refractive index material to the encapsulation organic layer 270. In a case where the touch sensor layer TSL and the overcoat layer OCL are further provided, the refractive indexes n6 and n7 of the touch protection layer YPVX and the overcoat material layer OC may be set to about 1.5 to about 1.7 by adding a high refractive index material to the touch protection layer YPVX and the overcoat material layer OC.

In this manner, the light transmittance of the light-transmitting parts TPA in the first sub-display area SDAa of the display device 1 can be improved.

Meanwhile, in a case where the first encapsulation inorganic layer 440 and the organic or inorganic layers on the first encapsulation inorganic layer 440 have the same refractive index, the light transmittance of the light-transmitting parts

# EP 4 753 429 A2

TPA in the first sub-display area SDAa of the display device 1 can be further improved because light incident upon the display panel 300 from each of the boundaries between the layers of the display panel 300 is not reflected. This becomes apparent from Table 2 below.

[Table 2]

| Refractive Index of First Layer | Refractive Index of Second Layer | Light Transmittance (%) |
| --- | --- | --- |
| 1.57 | 1.77 | 61.8 |
| 1.57 | 1.57 | 63.0 |
| 1.62 | 1.77 | 61.7 |
| 1.62 | 1.62 | 62.5 |

According to Table 2, light transmittance is relatively high when the first and second layers have the same refractive index.

Hereinafter a display device 1 according to another embodiment of the disclosure will be described, focusing mainly on the differences with the display device 1 of FIG. 1. Like reference numerals indicate like elements throughout the disclosure, and thus, detailed descriptions thereof will be omitted.

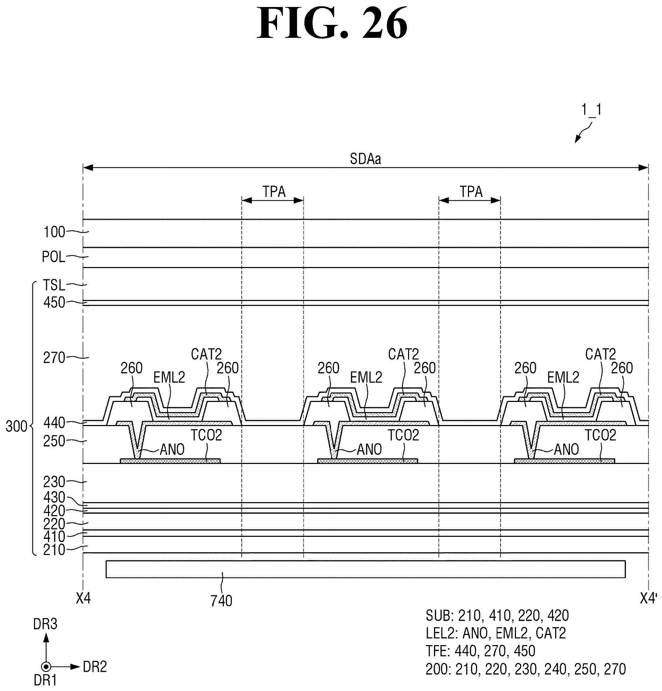

FIG. 26 is a cross-sectional view of a first sub-display area of a display device according to another embodiment of the disclosure.

Referring to FIG. 26, a polarizing plate POL, instead of an overcoat layer OCL, may be disposed on a display panel 300 of a display device 1. Specifically, a touch sensor layer TSL may be disposed on the display panel 300, the polarizing plate POL may be disposed on the touch sensor layer TSL, and a cover window 100 may be disposed on the polarizing plate POL.

In this case, as an overcoat layer OCL is not provided, the haze and the wavefront characteristic of the overcoat layer OCL may not be considered when considering the haze and the wavefront characteristic of the display panel 300 in light-transmitting parts TPA of a first sub-display area SDAa.

In concluding the detailed description, those skilled in the art will appreciate that many variations and modifications can be made to the preferred embodiments without substantially departing from the principles of the present invention. Therefore, the disclosed preferred embodiments of the invention are used in a generic and descriptive sense only and not for purposes of limitation.

The invention may also be defined by any of the following numbered clauses, which correspond to the claims of the parent application as filed.

1. A display device comprising:

a substrate including a first display area, a second display area, which is surrounded by the first display area and includes a light-transmitting part, and a third display area, which is disposed between the first display area and the second display area, wherein the light-transmitting part transmits light therethrough;
a first subpixel including a first thin-film transistor (TFT), which is disposed on the first display area of the substrate, and a first light-emitting element, which is disposed on the first TFT and is electrically connected to the first TFT;
a second subpixel including a second TFT, which is disposed on the third display area of the substrate, and a second light-emitting element, which is disposed on the second display area of the substrate and does not overlap with the second TFT in a plan view;
a thin-film encapsulation layer including a first encapsulation inorganic layer, which is disposed on the first and second subpixels, an encapsulation organic layer, which is disposed on the first encapsulation inorganic layer, and a second encapsulation inorganic layer, which is disposed on the encapsulation organic layer; and
a first transparent conductive layer disposed between the second TFT and the second light-emitting element to electrically connect the second TFT and the second light-emitting element,
wherein each of the first encapsulation inorganic layer, the encapsulation organic layer, and the second encapsulation inorganic layer has a refractive index of about 1.5 to about 1.7.

2. The display device of clause 1, further comprising:

a touch sensor layer disposed on the thin-film encapsulation layer,
wherein
the touch sensor layer includes a first touch insulating layer, which is disposed on the second encapsulation

22

inorganic layer, a first touch conductive layer, which is disposed on the first touch insulating layer, a second touch insulating layer, which is disposed on the first touch conductive layer, a second touch conductive layer, which is disposed on the second touch insulating layer, and a touch protection layer, which is disposed on the second touch conductive layer,

the first and second touch conductive layers do not overlap with the light-transmitting part in the plan view, and each of the first touch insulating layer, the second touch insulating layer, and the touch protection layer has a refractive index of about 1.5 to about 1.7.

3. The display device of clause 1 or 2, further comprising:

an overcoat layer disposed on the touch sensor layer,
wherein:

the overcoat layer includes an overcoat material layer, and
the overcoat material layer has a refractive index of about 1.5 to about 1.7.

4. The display device of clause 3 when also dependent on clause 2, wherein the first encapsulation inorganic layer, the encapsulation organic layer, the second encapsulation inorganic layer, the first touch insulating layer, the second touch insulating layer, the touch protection layer, and the overcoat layer have the same refractive index.

5. The display device of any preceding clause, further comprising:

a third subpixel including a third TFT, which is disposed on the third display area of the substrate and a third light-emitting element, which is disposed on the second display area of the substrate and does not overlap with the third TFT in the plan view;
a second transparent conductive layer disposed between the third TFT and the third light-emitting element to electrically connect the third TFT and the third light-emitting element;
a first via-insulating layer disposed between the substrate and the second and third light-emitting elements; and
a third via-insulating layer disposed between the first via-insulating layer and the second light-emitting element and between the first via-insulating layer and the third light-emitting element,
wherein
the second light-emitting element of the second subpixel and the third light-emitting element of the third subpixel are spaced apart from each other by the light-transmitting part,
the first transparent conductive layer is disposed between the third via-insulating layer and the second light-emitting element, and
the second transparent conductive layer is disposed between the first via-insulating layer and the third via-insulating layer.

6. The display device of any preceding clause, wherein

the first light-emitting element includes a first cathode, which is disposed below the first encapsulation inorganic layer,
the second light-emitting element includes a second cathode, which is disposed below the first encapsulation inorganic layer,
the display device further comprises an optical compensation layer, which is disposed between the second cathode and the first encapsulation inorganic layer,
an opening, which exposes the light-transmitting part, is defined in the second cathode,

the optical compensation layer includes a low refractive index layer, which is disposed on the second cathode, and a high refractive index layer, which is disposed on the low refractive index layer,
the low refractive index layer has a refractive index of about 1.5 or less, and
the high refractive index layer has a refractive index of about 1.8 or greater.

7. The display device of any preceding clause, wherein the encapsulation organic layer has a haze of about 4% or less;

and/or wherein the encapsulation organic layer has a peak-to-valley (P-V) wavefront value of 2 micrometers ($\mu$m);

and/or further comprising:

an optical device disposed below the substrate,
wherein the optical device is disposed to overlap with the second display area of the substrate in the plan view.

8. A display device comprising:

a substrate including a first display area, a second display area, which is surrounded by the first display area and includes a light-transmitting part, and a third display area, which is disposed between the first display area and the second display area, wherein the light-transmitting part transmits light therethrough;
thin-film transistors (TFTs) disposed on the substrate;
a first via-insulating layer disposed on the TFT, and overlapping with the first and second display areas in a plan view;
a second via-insulating layer disposed on the first via-insulating layer, wherein the second via-insulating layer overlaps with the first display area, but does not overlap with the second display area in the plan view;
a third via-insulating layer disposed on the second via-insulating layer and overlapping with the first and second display areas;
light-emitting elements disposed on the third via-insulating layer, and overlapping with the first and second display areas; and
a thin-film encapsulation layer disposed on the light-emitting elements,
wherein a haze of the second display area is less than a haze of the first display area.

9. The display device of clause 8, wherein a value of the haze of the second display area is about 4% or less;

and/or wherein the second display area has a smaller peak-to-valley (P-V) wavefront value than the first display area;

and/or wherein the second display area has a P-V wavefront value of about $2\mu$m or less.

10. The display device of clause 8 or 9, wherein

the light-emitting elements include a first light-emitting element, which overlaps with the first display area, but not with the second display area, and a plurality of second light-emitting elements, which overlap with the second display area, but not with the first display area in the plan view, and
the second light-emitting elements are spaced apart from each other by the light-transmitting part.

11. The display device of clause 10, further comprising:

a third display area disposed between the first display area and the second display area,
wherein
the TFTs include a first TFT, which is disposed on the first display area and electrically connected to the first light-emitting element, and a plurality of second TFTs, which are disposed on the third display area and electrically connected to the second light-emitting elements,
the first TFT overlaps with the first light-emitting element in the plan view, and
the second TFTs do not overlap with the second light-emitting elements in the plan view.

12. The display device of clause 10 or 11, wherein

each of the second light-emitting elements include a second cathode, which is disposed between the thin-film encapsulation layer and the third via-insulating layer, and
the second cathode defines an opening, which exposes the light-transmitting part.

13. The display device of clause 12, wherein

the thin-film encapsulation layer includes a first encapsulation inorganic layer, which is disposed on the second cathode, an encapsulation organic layer, which is disposed on the first encapsulation inorganic layer, and a second encapsulation inorganic layer, which is disposed on the encapsulation organic layer, and

each of the first encapsulation inorganic layer, the encapsulation organic layer, and the second encapsulation inorganic layer has a refractive index of about 1.5 to about 1.7.

14. A display device comprising:

a first display area including a first subpixel; and
a second display area surrounded by the first display area, and including a second subpixel and a light-transmitting part, wherein the light-transmitting part is adjacent to the second subpixel,
wherein the second display area has a smaller peak-to-valley (P-V) wavefront value than the first display area.

15. The display device of clause 14, wherein the second display area has a P-V wavefront value of about $2\mu m$; and/or wherein the second display area has a root mean square (RMS) wavefront value of about 0.4 or less.

**Claims**

1. A display device comprising:

a substrate including a first display area, a second display area, which is surrounded by the first display area and includes a light-transmitting part, and a third display area, which is disposed between the first display area and the second display area, wherein the light-transmitting part transmits light therethrough;
thin-film transistors (TFTs) disposed on the substrate;
a first via-insulating layer disposed on the TFT, and overlapping with the first and second display areas in a plan view;
a second via-insulating layer disposed on the first via-insulating layer, wherein the second via-insulating layer overlaps with the first display area, but does not overlap with the second display area in the plan view;
a third via-insulating layer disposed on the second via-insulating layer and overlapping with the first and second display areas;
light-emitting elements disposed on the third via-insulating layer, and overlapping with the first and second display areas; and
a thin-film encapsulation layer disposed on the light-emitting elements,
wherein a haze of the second display area is less than a haze of the first display area.

2. The display device of claim 1, wherein a value of the haze of the second display area is about 4% or less;

3. The display device of claim 1 or 2, wherein the second display area has a smaller peak-to-valley (P-V) wavefront value than the first display area.

4. The display device of claim 1, 2 or 3, wherein the second display area has a P-V wavefront value of about $2\ \mu m$ or less.

5. The display device of any preceding claim, wherein

the light-emitting elements include a first light-emitting element, which overlaps with the first display area, but not with the second display area, and a plurality of second light-emitting elements, which overlap with the second display area, but not with the first display area in the plan view, and
the second light-emitting elements are spaced apart from each other by the light-transmitting part.

6. The display device of claim 5, further comprising:

a third display area disposed between the first display area and the second display area,
wherein
the TFTs include a first TFT, which is disposed on the first display area and electrically connected to the first light-emitting element, and a plurality of second TFTs, which are disposed on the third display area and electrically connected to the second light-emitting elements,
the first TFT overlaps with the first light-emitting element in the plan view, and
the second TFTs do not overlap with the second light-emitting elements in the plan view.

7. The display device of claim 5 or 6, wherein

each of the second light-emitting elements include a second cathode, which is disposed between the thin-film encapsulation layer and the third via-insulating layer, and

the second cathode defines an opening, which exposes the light-transmitting part.

8. The display device of claim 7, wherein

the thin-film encapsulation layer includes a first encapsulation inorganic layer, which is disposed on the second cathode, an encapsulation organic layer, which is disposed on the first encapsulation inorganic layer, and a second encapsulation inorganic layer, which is disposed on the encapsulation organic layer, and

each of the first encapsulation inorganic layer, the encapsulation organic layer, and the second encapsulation inorganic layer has a refractive index of about 1.5 to about 1.7.

9. A display device comprising:

a first display area including a first subpixel; and

a second display area surrounded by the first display area, and including a second subpixel and a light-transmitting part, wherein the light-transmitting part is adjacent to the second subpixel,

wherein the second display area has a smaller peak-to-valley (P-V) wavefront value than the first display area.

10. The display device of claim 9, wherein the second display area has a P-V wavefront value of about 2 $\mu$m.

11. The display device of claim 9 or 10, wherein the second display area has a root mean square (RMS) wavefront value of about 0.4 or less.

# FIG. 1

DA: MDA, SDA
SDA: SDAa, SDAb

# FIG. 2

DA: MDA, SDA
300: 310, 320, 330, 340
500: SH, BH, CMH1, CAH
700: 710, 720, 730, 740, 750
740: 740a, 740b, 740c, 740d
900: CMH2
SDA: SDAa, SDAb

# FIG. 3

# FIG. 4

# FIG. 5

# FIG. 6

# FIG. 7

large MTF    small MTF

# FIG. 8

SDAb    SDAa    SDAb

HZ_t, WF_t

NDA

MDA

HZ_nt, WF_nt

SBA

310

320

330

DR3

DR2

DR1

# FIG. 9

# FIG. 10

PXL1: PXL1a, PXL1b, PXL1c, PXL1d
LEL1: LEL1a, LEL1b, LEL1c, LEL1d
TR1: TR1a, TR1b, TR1c, TR1d
PXL1a: LEL1a, TR1a
PXL1b: LEL1b, TR1b
PXL1c: LEL1c, TR1c
PXL1d: LEL1d, TR1d

# FIG. 11

# FIG. 12

SUB: 210, 410, 220, 420
BML: BML1, BML5
ACT: ACT1, ACT5
GAT1: G1, G5
GAT2: CAP1
SD1: S5, D5
SD2: CNE5

LEL1: ANO, EML1 CAT1
TFE: 440, 270, 450
200: 210, 220, 230, 240, 250, 270
OCL: BLF, OC, CF

# FIG. 13

A

OC
BLF
YPVX
YMTL2
YILD2
YMTL1
YILD1
450

TSL: YILD1, YMTL1, YMTL2, YILD2, YPVX

DR3

DR2

DR1

# FIG. 14

PXL1: PXL1a, PXL1b, PXL1c, PXL1d    PXL2: PXL2a, PXL2b, PXL2c, PXL2d
LEL1: LEL1a, LEL1b, LEL1c, LEL1d    LEL2: LEL2a, LEL2b, LEL2c, LEL2d
TR1: TR1a, TR1b, TR1c, TR1d         TR2: TR2a, TR2b, TR2c, TR2d
PXL1a: LEL1a, TR1a                  PXL2a: LEL2a, TR2a
PXL1b: LEL1b, TR1b                  PXL2b: LEL2b, TR2b
PXL1c: LEL1c, TR1c                  PXL2c: LEL2c, TR2c
PXL1d: LEL1d, TR1d                  PXL2d: LEL2d, TR2d

# FIG. 15

SDAb | SDAa

100
OC
BLF
TSL
450
270
440
260
250
240
230
ILD
GI2
GI1
430
420
220
410
210

300

CF_1

TCO2

CNE5

CAT2
260 EML2a 260

ANO

S5    D5

G1 CAP1 BML1
ACT1

G5 ACT5 BML5

X2

740    X2'

STa1

STa5

DR3

SUB: 210, 410, 220, 420
BML: BML1, BML5
ACT: ACT1, ACT5
GAT1: G1, G5
GAT2: CAP1

LEL2a: ANO, EML2a, CAT2
TFE: 440, 270, 450
200: 210, 220, 230, 240, 250, 270
OCL: BLF, OC, CF
SD1: S5, D5
SD2: CNE5
CF: CF_1

# FIG. 16

SDAb | SDAa

100
OC
BLF
TSL
450
270
440
260
250
240
230
ILD
GI2
GI1
430
420
220
410
210

300

CF_2

CAT2
260  EML2b  260

CNE5

S5   D5

ANO

TCO1   CN5

G1 / CAP1 BML1          G5 ACT5 BML5
ACT1

X3

STa1              STa5

740         X3'

DR3

SUB: 210, 410, 220, 420
BML: BML1, BML5
ACT: ACT1, ACT5
GAT1: G1, G5
GAT2: CAP1

LEL2b: ANO, EML2b, CAT2
TFE: 440, 270, 450
200: 210, 220, 230, 240, 250, 270
OCL: BLF, OC, CF
SD1: S5, D5
SD2: CNE5, CN5
CF: CF_2

# FIG. 17

# FIG. 18

SUB: 210, 410, 220, 420
LEL2: ANO, EML2, CAT2
TFE: 440, 270, 450
200: 210, 220, 230, 240, 250, 270
OCL: BLF, OC, CF

# FIG. 19

B

OC — HZ7

YPVX — HZ6

YILD2

YILD1

450

DR3
↑
● → DR2
DR1

TSL: YILD1, YILD2, YPVX

# FIG. 20

SUB: 210, 410, 220, 420
LEL2: ANO, EML2, CAT2
TFE: 440, 270, 450
200: 210, 220, 230, 240, 250, 270
OCL: BLF, OC, CF

# FIG. 21

OC ⁓ WF7

YPVX ⁓ WF6

YILD2 ⁓

YILD1 ⁓

450 ⁓

C

TSL: YILD1, YILD2, YPVX

DR3
↑
⊙→ DR2
DR1

# FIG. 22

SUB: 210, 410, 220, 420
LEL2: ANO, EML2, CAT2
TFE: 440, 270, 450
200: 210, 220, 230, 240, 250, 270
OCL: BLF, OC, CF

# FIG. 23

OC n7

YPVX n6

YILD2 n5

YILD1 n4

450 n3

D

TSL: YILD1, YILD2, YPVX

DR3
DR1 DR2

# FIG. 24

270 — n2

440 — n1

HNL — n-HNL

LNL — n-LNL

CPL

CAT2

E

DR3
DR1 → DR2

O-comp: HNL, LNL

# FIG. 25

# FIG. 26

1_1

SDAa

TPA

TPA

100

POL

TSL
450

270

260
EML2
CAT2
260

260
EML2
CAT2
260

260
EML2
CAT2
260

300

440
250

ANO
TCO2

ANO
TCO2

ANO
TCO2

230
430
420
220
410
210

X4

740

X4'

DR3

DR2

DR1

SUB: 210, 410, 220, 420
LEL2: ANO, EML2, CAT2
TFE: 440, 270, 450
200: 210, 220, 230, 240, 250, 270